# EUROPEAN PATENT SPECIFICATION

(11) **EP 3 745 454 B1**
(45) Date of publication and mention of the grant of the patent: **31.05.2023**
(21) Application number: 18906604.6
(22) Date of filing: 29.08.2018
(51) Int. Cl.: H01L 23/367, H01L 23/40, H01L 23/36, H01L 23/427

(54) **HEAT-DISSIPATION UNIT AND ELECTRONIC DEVICE**
WÄRMEABLEITUNGSEINHEIT UND ELEKTRONISCHE VORRICHTUNG
UNITÉ DE DISSIPATION DE CHALEUR ET DISPOSITIF ÉLECTRONIQUE

(30) Priority: 14.02.2018 CN 201810152072
(43) Date of publication of application: 02.12.2020
(73) Proprietor: HUAWEI TECHNOLOGIES CO., LTD., Shenzhen, Guangdong 518129 (CN)
(72) Inventor: GUO, Ye, Shenzhen, Guangdong 518129 (CN); SHI, Lei, Shenzhen, Guangdong 518129 (CN); ZHANG, Zhipeng, Shenzhen, Guangdong 518129 (CN); ZHANG, Yonglan, Shenzhen, Guangdong 518129 (CN); CHEN, Yang, Shenzhen, Guangdong 518129 (CN); FAN, Yi, Shenzhen, Guangdong 518129 (CN)
(74) Representative: Grünecker Patent- und Rechtsanwälte PartG mbB
(86) International application number: PCT/CN2018/102900
(87) International publication number: WO 2019/157807

(56) References cited:
- CN-A- 1 983 575
- CN-A- 106 328 612
- CN-Y- 201 213 344
- US-A1- 2008 284 005
- US-A1- 2009 168 355
- US-A1- 2013 313 715
- US-B1- 6 493 233

## Description

### TECHNICAL FIELD

This application relates to the field of electronic devices, and more specifically, to a heat dissipation device and an electronic device.

### BACKGROUND

A printed circuit board (printed circuit board, PCB) is widely used in the field of electronic products. One or more main chips are usually arranged on the PCB, and a plurality of peripheral devices are also arranged around each main chip on the PCB. Because of an adjacent layout among a plurality of main chips and between the main chips and the peripheral devices, with an ever-increasing power density, a requirement for heat dissipation is increasingly higher. Consequently, it is impossible to meet heat dissipation of a single main chip and peripheral devices by adding individual radiators. US 2009/168355 A1 relates generally to a heat sink assembly, and more particularly to a heat sink assembly adapted for removing heat from multiple electronic heat generating components of differing heights. US 6 493 233 B1 concerns computer systems in general, and techniques for mounting PCBs to computer system chassis in particular. US 2008/284005 A1 relates to a structure of a fastener for heat sinks, and in particular, to one which can be easily engaged with a heat sink, but will not be easily disengaged therefrom.

Considering that the main chip has a higher requirement for the heat dissipation, therefore, the main chip dissipates heat separately, and all peripheral devices use a common radiator for heat dissipation. To fix the two types of radiators, the common radiator needs to be fastened with the PCB through a connecting device, and an independent radiator corresponding to the main chip is pre-fastened to the common radiator through the connecting device.

In this case, a relatively large quantity of connecting devices are needed to fix the radiators, and a relatively large area of the PCB and the radiators is occupied. With continuous upgrading of products, an impact of this problem on a PCB layout becomes increasingly prominent.

### SUMMARY

This application provides a heat dissipation device and an electronic device, to reduce a PCB area occupied by a fastening device and increase an area of a heat sink. The invention is defined according to the independent claims. The dependent claims recite advantageous embodiments of the invention.

According to a first aspect, a heat dissipation device is provided. The heat dissipation device includes a first radiator, a second radiator and a first connecting device, where the first radiator and the second radiator are fastened onto a printed circuit board PCB through the first connecting device; the first radiator is disposed above a first electronic device, and the second radiator is disposed above a second electronic device; the first electronic device and the second electronic device are fixed on the PCB; the first connecting device includes a first fixing pipe, a first fixing post and a first elastic element; the first radiator is fixed with the first fixing pipe; the first fixing post is sleeved in the first fixing pipe, an upper surface of the first fixing pipe abuts against a lower surface of a first convex portion of the first fixing post, and a lower surface of the first fixing pipe abuts against an upper surface of the PCB; the first fixing post runs through the second radiator and the first radiator from top to bottom; the first elastic element is disposed between the second radiator and a second convex portion of the first fixing post, the first elastic element is sleeved on an outer side of the first fixing post and is in a compressed state, and the second convex portion is located above the first convex portion; and the PCB is fixed with the first fixing post.

In the foregoing heat dissipation device, the first fixing post is fixed with the PCB, and the first fixing pipe is pressed through contact between the first convex portion and the first fixing pipe. Because the first fixing pipe is fixed with the first radiator, the first radiator is fixed. The first elastic element is disposed between the second convex portion of the first fixing post and the second radiator. The second radiator is fixed by compressing the first elastic element to exert force on the second radiator. In this way, in the heat dissipation device, the connecting device may be used, to fix the first radiator and the second radiator simultaneously, so that there is no need to fix the first radiator and the second radiator respectively with two groups of independent connecting devices, thereby reducing the occupied PCB area and increasing the area of the heat sink.

In addition, because the quantity of connecting devices of the heat dissipation device is reduced, costs of the heat dissipation device may be further reduced.

In a possible implementation, the heat dissipation device further includes a third radiator, and the third radiator is disposed above a third electronic device and is adjacent to the second radiator in a same plane; the second radiator and the third radiator are fastened on the PCB through the first connecting device and a second connecting device; the second connecting device includes a second fixing pipe, a second fixing post and a second elastic element; the second radiator is fixed with the second fixing pipe; the second fixing post is sleeved in the second fixing pipe, an upper surface of the second fixing pipe abuts against a lower surface of a second convex portion of the second fixing post, and a lower surface of the second fixing pipe abuts against the upper surface of the PCB; the second fixing post runs through the second radiator and the first radiator from top to bottom; the second elastic element is disposed between the second radiator and the second convex portion of the second fixing post, the second elastic element is sleeved on an outer side of the second fixing post and is in a compressed state, and the second convex portion is located above the first convex portion; the PCB is fixed with the second fixing post; a bracket is fixed on a side of the third radiator close to the second radiator, and two end portions of the bracket are provided with through holes; through the through hole of one end portion of the bracket, one end portion of the bracket is sleeved between the second convex portion and a third convex portion of the first fixing post; a third elastic element is disposed between one end portion of the bracket and the third convex portion of the first fixing post, and the elastic element is sleeved on the outer side of the first fixing post and is in a compressed state; the third convex portion of the first fixing post is located above the second convex portion of the first fixing post; and through the through hole on the other end of the bracket, the other end portion of the bracket is sleeved between the second convex portion and a third convex portion of the second fixing post; a fourth elastic element is disposed between the other end portion of the bracket and the third convex portion of the second fixing post, and the fourth elastic element is sleeved on the outer side of the second fixing post and is in a compressed state; and the third convex portion of the second fixing post is located above the second convex portion of the second fixing post. In the foregoing heat dissipation device, based on that the first radiator and second radiator are simultaneously fixed by using one group of connecting devices, by sleeving, between the second convex portion and the third convex portion of the fixing post, the through holes on the two end portions of the bracket fixed with the third radiator and disposing the elastic element between the bracket and the third convex portion, the same group of connecting devices may be further used, to fix the adjacent second radiator and third radiator, thereby further reducing a quantity of connecting devices, reducing the occupied PCB area, and increasing the area of the heat sink.

In addition, by using the foregoing heat dissipation device, the costs of the heat dissipation devices may be further reduced.

In a possible implementation, the bracket includes two first cross plates, a second cross plate and two upright plates, where the two first cross plates are respectively on the two end portions of the bracket and both disposed above the second cross plate, and the two upright plates are separately disposed between the two first cross plates and the second cross plate; the third radiator is fixed with the second cross plate; and the first cross plates are provided with the through holes.

The first cross plates, the second cross plate and the first upright plates of the foregoing heat dissipation device are combined into a concave bracket. By using the concave bracket, a heat sink extends from above the concave shape, thereby further increasing the area of the heat sink.

In a possible implementation, an upper surface of an edge part of a base board of the second radiator is provided with a groove, and a base board of the third radiator extends into the groove; and a part that is of the base board of the third radiator and that extends into the groove is fixed with the bracket.

In the foregoing heat dissipation device, the base board of the second radiator and the base board of the third radiator are placed in a staggered manner, and the bracket is fixed at a location at which the base boards are staggered. One group of connecting devices may be used, to fix the second radiator and the third radiator without affecting heights of the radiators.

In a possible implementation, a heat sink exists above or below the bracket.

In the foregoing heat dissipation device, the heat sink belonging to the first radiator or the second radiator or the third radiator is disposed above or below the bracket, thereby further increasing the area of the heat sink.

In a possible implementation, a radius that is of a part of the first fixing post and that is above the upper surface of the fixing pipe is greater than a radius of a part that is of the first fixing post and that is below the upper surface of the fixing pipe; and the first convex portion of the first fixing post is a part that is of the first fixing post and that is between the second convex portion of the first fixing post and the upper surface of the first fixing pipe.

In the foregoing heat dissipation device, a step-shaped fixing post is used, to fix the second radiator and the first radiator simultaneously. Such a fixing post facilitates production and processing.

In a possible implementation, the first fixing post is sleeved in the first fixing pipe in a threaded connection manner.

The fixing pipe of the foregoing heat dissipation device is sleeved on the fixing post in a threaded connection manner, so that during mounting, the first radiator and the second radiator can be first fixedly connected, and then the first radiator and the second radiator after fixed connection are connected to the PCB. This mounting manner is easily implemented.

In a possible implementation, the first radiator is fixed with a convex portion of the first fixing pipe in a riveted manner.

In a possible implementation, a fixing plate is disposed below the PCB, the fixing plate is fixed with the PCB, and the first fixing post runs through the PCB and is fixedly connected to the fixing plate in a threaded connection manner.

According to a second aspect, a heat dissipation device is provided. The heat dissipation device includes a first radiator, a second radiator and a first connecting device, where the first radiator and the second radiator are fastened onto a printed circuit board PCB through the first connecting device; the first radiator is disposed above a first electronic device, and the second radiator is disposed above a second electronic device; the first electronic device and the second electronic device are fixed on the PCB; the first connecting device includes a first fixing pipe, a first fixing post and a first elastic element; the first radiator is fixed with the first fixing pipe through a first convex portion of the fixing pipe; the first fixing post is sleeved in the first fixing pipe, an upper surface of the first fixing pipe abuts against a lower surface of a convex portion of the first fixing post, and a lower surface of the first fixing pipe abuts against an upper surface of the PCB; the first fixing pipe and the first fixing post run through the second radiator and the first radiator from top to bottom; the first elastic element is disposed between the second radiator and the convex portion of the first fixing post, and the first elastic element is sleeved on an outer side of the first fixing pipe and is in a compressed state; and the PCB is fixed with the first fixing post.

In the foregoing heat dissipation device, the fixing post is fixed with the PCB, and the fixing pipe is pressed through the fixing post. Because the first convex portion of the fixing pipe is fixed with the first radiator, the first radiator is fixed; the first elastic element is disposed between the convex portion of the fixing post and the second radiator, and the second radiator is fixed by compressing the first elastic element to exert force on the second radiator. In this way, in the heat dissipation device, the connecting device may be used, to fix the first radiator and the second radiator simultaneously, so that there is no need to fix the first radiator and the second radiator respectively with two groups of independent connecting devices, thereby reducing the occupied PCB area and increasing the area of the heat sink. In addition, because the quantity of connecting devices of the heat dissipation device is reduced, costs of the heat dissipation device may be further reduced.

In a possible implementation, the heat dissipation device further includes a third radiator, and the third radiator is disposed above a third electronic device and is adjacent to the second radiator in a same plane; the second radiator and the third radiator are fastened on the PCB through the first connecting device and a second connecting device; the second connecting device includes a second fixing pipe, a second fixing post and a second elastic element; the second radiator is fixed with the second fixing pipe through a second convex portion of the second fixing pipe; the second fixing post is sleeved in the second fixing pipe, an upper surface of the second fixing pipe abuts against a lower surface of a convex portion of the second fixing post, and a lower surface of the second fixing pipe abuts against the upper surface of the PCB; the second fixing pipe and the second fixing post run through the second radiator and the first radiator from top to bottom; the second elastic element is disposed between the second radiator and the convex portion of the second fixing post, and the second elastic element is sleeved on an outer side of the second fixing pipe and is in a compressed state; the PCB is fixed with the second fixing post; a bracket is fixed on a side of the third radiator close to the second radiator, and two end portions of the bracket are provided with through holes; through the through hole of one end portion of the bracket, one end portion of the bracket is sleeved between a second convex portion of the first fixing pipe and the convex portion of the first fixing post; a third elastic element is disposed between one end portion of the bracket and the convex portion of the first fixing post, and the elastic element is sleeved on the outer side of the first fixing pipe and is in a compressed state; the second convex portion of the first fixing pipe is located above the first convex portion of the first fixing pipe; and through the through hole on the other end portion of the bracket, the other end portion of the bracket is sleeved between the second convex portion of the second fixing pipe and the convex portion of the second fixing post; a fourth elastic element is disposed between the other end portion of the bracket and the convex portion of the second fixing post, and the fourth elastic element is sleeved on the outer side of the second fixing pipe and is in a compressed state; and the second convex portion of the second fixing pipe is located above a first convex portion of the second fixing pipe. In the foregoing heat dissipation device, based on that the first radiator and the second radiator are simultaneously fixed by using one group of connecting devices, by sleeving, between the second convex portion of the fixing pipe and the convex portion of the fixing post of the connecting device, the through holes on the two end portions of the bracket fixed with the third radiator, where the second convex portion of the fixing pipe and the convex portion of the fixing post of the connecting device are on two ends, and disposing the elastic element between the bracket and the convex portion of the fixing post, the same group of connecting devices may be further used, to fix the adjacent second radiator and third radiator, thereby further reducing a quantity of connecting devices, reducing the occupied PCB area, and increasing the area of the heat sink.

In addition, by using the foregoing heat dissipation device, the costs of the heat dissipation devices may be further reduced.

In a possible implementation, the bracket includes two first cross plates, a second cross plate and two upright plates, where the two first cross plates are respectively on the two end portions of the bracket and both disposed above the second cross plate, and the two upright plates are separately disposed between the two first cross plates and the second cross plate; the third radiator is fixed with the second cross plate; and the first cross plates are provided with the through holes.

The first cross plates, the second cross plate and the first upright plates of the foregoing heat dissipation device are combined into a concave bracket. By using the concave bracket, a heat sink extends from above the concave shape, thereby further increasing the area of the heat sink.

In a possible implementation, an upper surface of an edge part of a base board of the second radiator is provided with a groove, and a base board of the third radiator extends into the groove; and a part that is of the base board of the third radiator and that extends into the groove is fixed with the bracket.

In the foregoing heat dissipation device, the base board of the second radiator and the base board of the third radiator are placed in a staggered manner, and the bracket is fixed at a location at which the base boards are staggered, so that the connecting devices configured to fix the second radiator and the third radiator are integrated into one without affecting heights of the radiators.

In a possible implementation, a heat sink exists above or below the bracket.

In the foregoing heat dissipation device, the heat sink belonging to the first radiator or the second radiator or the third radiator is disposed above or below the bracket, thereby further increasing the area of the heat sink.

In a possible implementation, the first fixing post is sleeved in the first fixing pipe in a threaded connection manner.

The fixing post of the foregoing heat dissipation device is sleeved in the fixing pipe in a threaded connection manner, so that during mounting, the first radiator and the second radiator can be first fixedly connected, and then the first radiator and the second radiator after fixed connection are connected to the PCB. This mounting manner is easily implemented.

In a possible implementation, the first radiator is fixed with the first convex portion of the first fixing pipe in a riveted manner.

In a possible implementation, a fixing plate is disposed below the PCB, the fixing plate is fixed with the PCB, and the first fixing post runs through the PCB and is fixedly connected to the fixing plate in a threaded connection manner.

According to a third aspect, an electronic device is provided. The electronic device includes a printed circuit board PCB and the heat dissipation device according to any one of the foregoing aspects or any one of the possible implementations of the any aspect.

### BRIEF DESCRIPTION OF DRAWINGS

FIG. 1 is a schematic structural diagram of a shared separate floating radiator according to an embodiment of this application;
FIG. 2 is a comparison schematic diagram of a space avoiding a fastener of a fastening manner of a shared separate floating radiator;
FIG. 3 is a schematic structural diagram of a shared conjoined floating radiator according to an embodiment of this application;
FIG. 4 is a comparison schematic diagram of a space avoiding a fastener of a fastening manner of a shared conjoined floating radiator;
FIG. 5 is a schematic structural diagram of a heat dissipation device according to an embodiment of this application;
FIG. 6 is a schematic structural diagram of another heat dissipation device according to an embodiment of this application;
FIG. 7 is a schematic structural diagram of another heat dissipation device according to an embodiment of this application;
FIG. 8 is a schematic diagram of a staggered manner of a base board of a second radiator and a base board of a third radiator according to an embodiment of this application;
FIG. 9 is a schematic structural diagram of a bracket and a base board that are fastened by a double-layer spring screw according to an embodiment of this application;
FIG. 10 is a schematic structural diagram of a bracket, a base board and a heat sink that are fastened by a double-layer spring screw according to an embodiment of this application;
FIG. 11 is another schematic diagram of a heat dissipation device fastened by a double-layer spring screw according to an embodiment of this application;
FIG. 12 is a schematic diagram of a space avoiding a fastener fastened by a double-layer spring screw in a heat dissipation device according to an embodiment of this application;
FIG. 13 is a schematic diagram of a shared conjoined floating radiator of three main chips according to an embodiment of this application;
FIG. 14 is a schematic structural diagram of another heat dissipation device according to an embodiment of this application;
FIG. 15 is schematic structural diagram of another shared separate floating radiator according to an embodiment of this application;
FIG. 16 is a schematic structural diagram of another heat dissipation device according to an embodiment of this application;
FIG. 17 is a schematic structural diagram of another heat dissipation device according to an embodiment of this application;
FIG. 18 is a schematic structural diagram of another heat dissipation device according to an embodiment of this application;
FIG. 19 is a schematic diagram of a space avoiding a fastener according to an embodiment of this application; and
FIG. 20 is a schematic structural diagram of another heat dissipation device according to an embodiment of this application.

### DESCRIPTION OF EMBODIMENTS

The technical solutions in embodiments of this application may be applied to the field of electronic devices, or may be applied to any other suitable field in which connecting devices need to be reduced.

A radiator includes a base board and a heat sink disposed on the base board. By placing a radiator above an electronic device and filling a thermal conductive pad or thermal conductive silicone grease between the electronic device and the base board (so that the base board comes into effective contact with the electronic device), heat generated by the electronic device is transferred to the radiator, thereby cooling the electronic device.

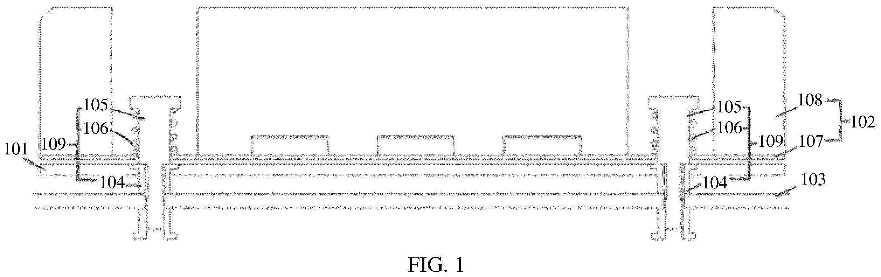

The following describes the technical solutions of this application in detail with reference to FIG. 1 to FIG. 20.

It should be noted that in the embodiments of this application, when a component is "fixedly connected" or "connected" to another component, or when a component is "fixed" to another component, it may be directly on the other component, or there may be an intermediate component.

FIG. 1 is a schematic structural diagram of a shared separate floating radiator according to an embodiment of this application. As shown in FIG. 1, the shared separate floating radiator includes a first radiator 101, a second radiator 102 and a connecting device 109. The first radiator 101 is disposed above all peripheral components (not shown in FIG. 1), and is locked on a surface of a PCB 103 by sharing the connecting device 109 with the second radiator 102; and the second radiator 102 is disposed above a main chip (not shown in FIG. 1), and pre-fastened with the first radiator 101 through the connecting device 109.

The second radiator 102 includes a floating base board 107 and a heat sink 108. The connecting device 109 includes a first fixing post 105, a first elastic element 106 and a fixing pipe 104. When the main chip comes into contact with the floating base board 107, the floating base board 107 is lifted, the first elastic element 106 is compressed, and the floating base board 107 is separated from the first radiator 101. In this case, force exerted on the main chip can be accurately controlled by designing a compression amount of the first elastic element 106. At the same time, the first radiator 101 is pressed by the first fixing post 105, thereby implementing heat dissipation of peripheral devices (not shown in FIG. 1) tightly close to the first radiator 101.

Because the first elastic element 106 may be configured to adjust force exerted on the main chip, due to a small difference between the height of the main chip and the height of the first elastic element 106, thermal conductive silicone grease may be filled to implement heat dissipation; and a thermal conductive pad needs to be filled between the first radiator 101 and the peripheral devices, to implement heat dissipation.

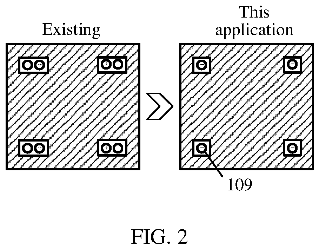

FIG. 2 is a comparison schematic diagram of a space avoiding a fastener of a fastening manner of a shared separate floating radiator.

In an existing fastening manner of a shared separate floating radiator, a first radiator and a second radiator need to be fixed separately. The first radiator is fixed with a PCB through four connecting devices (including a fastening screw and a fastening pillar, where the fastening pillar is fixed with the first radiator, and the fastening screw is fixed with the PCB by running through the fastening pillar), and then the second radiator is pre-fastened with the first radiator through four connecting devices (including a floating screw, a floating spring and a floating riveting column, where the floating riveting column is fixed on the first radiator, the floating spring is sleeved on an outer side of the floating riveting column, the floating screw is screwed into the floating riveting column and is fixed with the floating riveting column, and presses the floating spring simultaneously, and then the floating spring presses the second radiator). Therefore, in the existing shared separate floating radiator, the first radiator and the second radiator need to be fixed by using eight connecting devices, including 20 fasteners of 5 types: a floating screw, a floating spring, a floating riveting column, a fastening screw and a fastening pillar. Consequently, the cost is not only relatively high, but also an occupied area of a heat sink is increased, and loss of heat dissipation performance is serious.

In the heat dissipation device in this embodiment of this application, the connecting devices of the second radiator and the connecting devices of the first radiator are integrated into one group of connecting devices, and only four connecting devices 109 are required. The fasteners are optimized as a total of 12 fasteners of three types: the first fixing post 105, a fixing pipe 104 and a first elastic element 106, so that a radiator area occupied by hole sites is reduced by approximately 1/2.

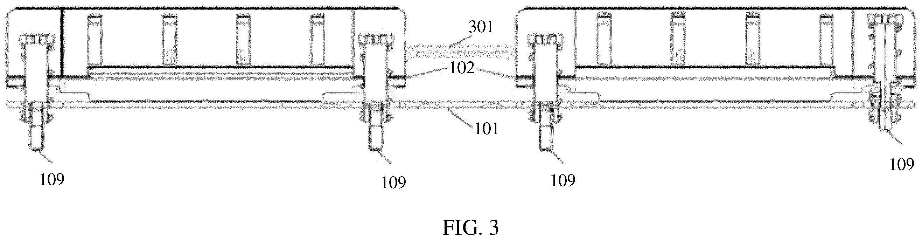

FIG. 3 is a schematic structural diagram of a shared conjoined floating radiator according to an embodiment of this application. In FIG. 3, only two conjoined floating radiators are used as an example for description, and this embodiment of this application is not limited thereto. For example, more or fewer main chips share a conjoined floating radiator.

A shared conjoined floating radiator is applicable to heat dissipation among a plurality of chips. In FIG. 3, there are two second radiators 102, and the two radiators 102 are connected to each other through a heat pipe 301 to achieve an average temperature. From a perspective shown in FIG. 3, two connecting devices 109 are used for fixation separately on either side of each radiator 102.

Similarly, the first radiator 101 is disposed above all the peripheral devices, and is locked on the surface of the PCB 103 by sharing the connecting device 109 with the second radiator 102; and the second radiator 102 is disposed above the main chip (not shown in FIG. 1), and pre-fastened with the first radiator 101 through the connecting device 109.

The second radiator 102 includes the floating base board 107 and a heat sink 108. The connecting device 109 includes the first fixing post 105, the first elastic element 106 and the fixing pipe 104. When the main chip comes into contact with the floating base board 107, the floating base board 107 is lifted, the first elastic element 106 is compressed, and the floating base board 107 is separated from the first radiator 101. In this case, force exerted on the main chip can be accurately controlled by designing the compression amount of the first elastic element 106. At the same time, the first radiator 101 is pressed by the first fixing post 105 to ensure fastening reliability of the first radiator 101, thereby implementing heat dissipation of the peripheral devices (not shown in FIG. 3) tightly close to the first radiator 101.

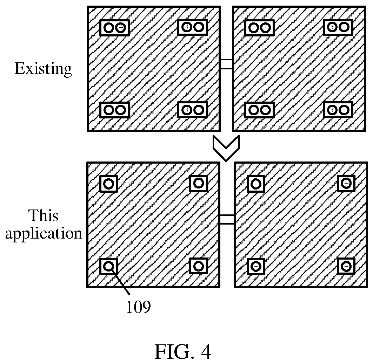

FIG. 4 is a comparison schematic diagram of a space avoiding a fastener of a fastening manner of a shared conjoined floating radiator.

As shown in FIG. 4, in an existing shared conjoined floating radiator, to fix a first radiator and a second radiator, at least 16 connecting devices, including 36 fasteners of 5 types: a floating screw, a floating spring, a floating riveting column, a fastening screw and a fastening pillar need to be used. Moreover, if a distance between main chips is relatively long, a total of four connecting devices need to be arranged between two main chips. Consequently, not only a quantity of fasteners is increased, but also an occupied area of a heat sink is increased, and loss of heat dissipation performance is serious.

In the heat dissipation device in this embodiment of this application, the connecting devices of the second radiator and the connecting devices of the first radiator are integrated into one group of connecting devices, and only four connecting devices 109 are required. The fasteners are optimized as a total of 24 fasteners of three types: the first fixing post 105, the fixing pipe 104 and the first elastic element 106, so that a radiator area occupied by hole sites is reduced by approximately 1/2.

It should be understood that an application scenario in this embodiment of this application is not limited to a separate floating radiator and a conjoined floating radiator, and can also be applied to all floating radiators.

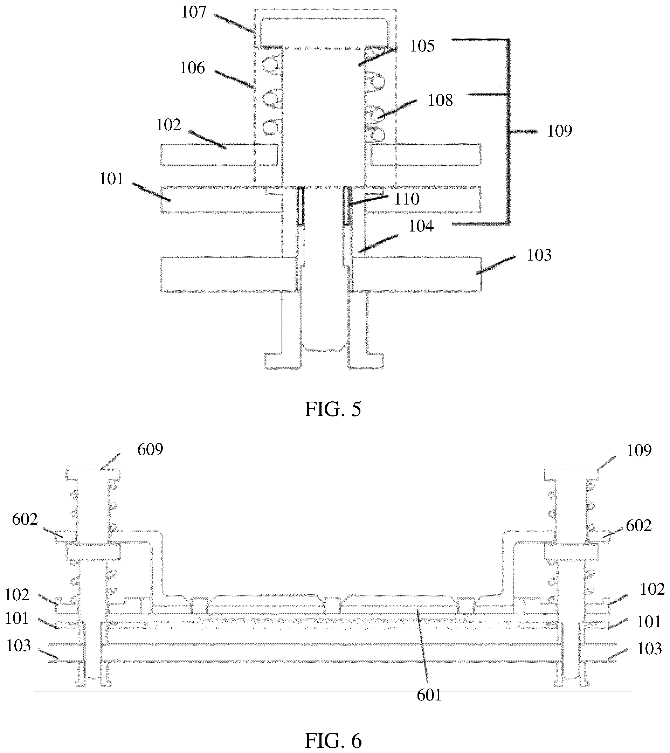

A manner of connection among the first radiator 101, the second radiator 102, and the PCB in FIG. 1 is the same as that in FIG. 3. The manner of connection among the three is described in detail below with reference to FIG. 5.

FIG. 5 is a schematic structural diagram of a heat dissipation device according to an embodiment of this application. As shown in FIG. 5, the heat dissipation device includes a first radiator 101, a second radiator 102 and a first connecting device 109, where the first radiator 101 and the second radiator 102 are fastened onto a printed circuit board PCB 103 through the first connecting device 109; the first radiator 101 is disposed above a first electronic device (not shown in FIG. 5), and the second radiator 102 is disposed above a second electronic device (not shown in FIG. 5); the first electronic device and the second electronic device are fixed on the PCB 103; the connecting device 109 includes a first fixing pipe 104, a first fixing post 105 and a first elastic element 106; the first radiator 101 is fixed with the first fixing pipe 104; the first fixing post 105 is sleeved in the first fixing pipe 104, an upper surface of the first fixing pipe 104 abuts against a lower surface of a first convex portion 502 of the first fixing post 105, and a lower surface of the first fixing pipe 104 abuts against an upper surface of the PCB 103; the first fixing post 105 runs through the second radiator 102 and the first radiator 101 from top to bottom; the first elastic element 106 is disposed between the second radiator 102 and a second convex portion 501 of the first fixing post 105, the first elastic element 106 is sleeved on an outer side of the first fixing post 105 and is in a compressed state, and the second convex portion 501 is located above the first convex portion 502; and the PCB 103 is fixed with the first fixing post 105. Optionally, the first electronic device and the second electronic device may be two types of electronic devices with different functions.

For example, the first electronic device may be a peripheral component on a circuit board, and the second electronic device may be a main chip on the circuit board. Optionally, the first electronic device and the second electronic device may be a same type of electronic devices. Because different electronic devices have different requirements for heat dissipation, different radiators are selected for heat dissipation. For example, the first electronic device and the second electronic device may both be peripheral devices on the circuit board or the main chips on the circuit board. Optionally, the first radiator 101 may be a shared bracket capable of dissipating heat, with a gap at a corresponding location of the second electronic device for placing the second radiator 102.

A shape of the gap in the shared bracket is not limited in this embodiment of this application, and may be, for example, a square shape, a round shape, a hexagon shape, or the like.

Specifically, a specific shape of the gap may be determined based on a shape, a production process, or another requirement of a chip on which heat dissipation needs to be performed.

A manner of fixing the first radiator 101 and the fixing pipe 104 is not limited in this embodiment of this application. For example, the first radiator 101 and the fixing pipe 104 may be fixed in a riveted manner, a threaded connection manner, or any other appropriate fixing manner.

A shape of the first fixing pipe 104 is not limited in this embodiment of this application, for example, the first fixing pipe 104 may be a round pipe, a square pipe, a hexagon tube, or the like.

Optionally, the first fixing pipe 104 may be a riveting column.

Optionally, the first fixing pipe 104 matches the first fixing post 105, for example, they are both round.

A shape of the first fixing post 105 is not limited in this embodiment of this application, for example, the first fixing post 105 may be a circular column, a square column, a hexagonal column, or the like.

Optionally, the first fixing post 105 may be a screw or a screw bolt.

Optionally, as shown in FIG. 5, a radius of a part that is of the first fixing post 105 and that is above the upper surface of the first fixing pipe 104 is greater than a radius of a part that is of the first fixing post 105 and that is below the upper surface of the first fixing pipe 104. The first convex portion 502 may be a part that is of the first fixing post 105 and that is between the second convex portion 501 and the upper surface of the first fixing pipe 104. In this case, the first elastic element 106 is sleeved on the first convex portion 502.

A step-shaped fixing post is used, to fix the second radiator and the first radiator simultaneously. Such a fixing post facilitates production and processing.

Optionally, the first fixing pipe 104 and the first fixing post 105 may be connected through a screw thread 110. The screw thread 110 may include an external screw thread disposed on the first fixing post 105 and an internal screw thread disposed in the first fixing pipe 104.

In this solution, the first fixing pipe 104 is sleeved on the first fixing post 105 in a threaded connection manner, so that during mounting, the first radiator 101 and the second radiator 102 can be first fixedly connected, and then the first radiator 101 and the second radiator 102 after fixed connection are connected to the PCB 103. This mounting manner is easily implemented.

Optionally, the first convex portion 502 of the first fixing post may be a sheet that encircles the fixing post 105.

A shape of the sheet is not limited in this embodiment of this application, for example, the shape of the sheet may be round, square, hexagonal, zigzag, or the like. Optionally, the first convex portion 502 of the first fixing post and the first fixing post 105 may be integrally processed and formed.

Optionally, the first convex portion 502 of the first fixing post and the first fixing post 105 may be assembled and fixed together.

Optionally, the second convex portion 501 of the first fixing post may be a sheet that encircles the first fixing post 105.

A shape of the sheet is not limited in this embodiment of this application, for example, the shape of the sheet may be round, square, hexagonal, zigzag, or the like. Optionally, the second convex portion 501 of the first fixing post and the first fixing post 105 may be integrally processed and formed.

A manner of integral processing is used to facilitate processing and production of the first fixing post 105.

Optionally, the second convex portion 501 of the first fixing post and the first fixing post 105 may be assembled and fixed together.

By using a manner of assembling and fixation, use of the fixing post may be more flexible.

Optionally, the second convex portion 501 of the first fixing post is a screw cap of a screw.

Optionally, the first elastic element may be a spring.

It should be understood that descriptions such as above, upper surface, lower surface, and the like in this embodiment of this application are described only as relative directions, and should not be understood as being the absolute above, upper surface, lower surface, and the like. For example, directions of the first electronic device and the second electronic device may be seen as the above, the upper surface, the lower surface, or the like of a reference direction. As the directions of the first electronic device and the second electronic device are different, the above, the upper surface, and the lower surface may also change accordingly.

In the foregoing heat dissipation device, the first fixing post is fixed with the PCB, and the fixing pipe is pressed through contact between the first convex portion and the fixing pipe. Because the fixing pipe is fixed with the first radiator, the first radiator is fixed. The first elastic element is disposed between the second convex portion of the fixing post and the second radiator. The second radiator is fixed by compressing the first elastic element to exert force on the second radiator. In this way, in the heat dissipation device, the connecting device may be used, to fix the first radiator and the second radiator simultaneously, so that there is no need to fix the first radiator and the second radiator respectively with two groups of independent connecting devices, thereby reducing the occupied PCB area and increasing the area of the heat sink.

In addition, because the quantity of connecting devices of the heat dissipation device is reduced, costs of the heat dissipation device may be further reduced.

Optionally, the second radiator 102 may be a floating radiator.

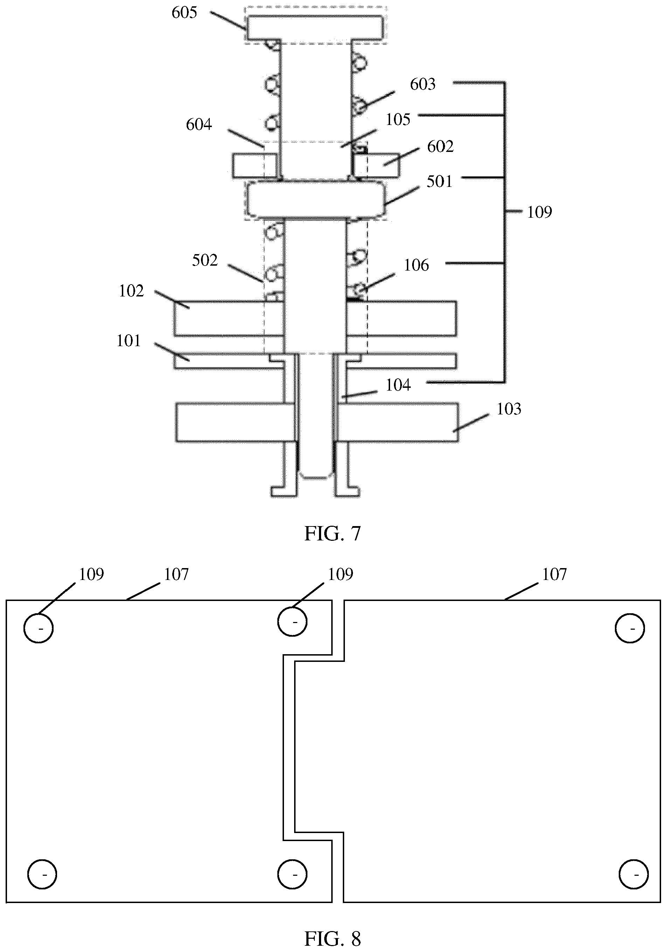

FIG. 6 and FIG. 7 are another schematic structural diagram of a heat dissipation device according to an embodiment of this application.

Optionally, as shown in FIG. 6, the heat dissipation device further includes a third radiator 601, and the third radiator 601 is disposed above a third electronic device (not shown in FIG. 6) and is adjacent to the second radiator 102 in a same plane; the second radiator 102 and the third radiator 601 are fastened on the PCB 103 through the first connecting device 109 and a second connecting device 609; the second connecting device 609 includes a second fixing pipe, a second fixing post and a second elastic element; the second radiator 102 is fixed with the second fixing pipe; the second fixing post is sleeved in the second fixing pipe, an upper surface of the second fixing pipe abuts against a lower surface of a second convex portion of the second fixing post, and a lower surface of the second fixing pipe abuts against an upper surface of the PCB 103; the second fixing post runs through the second radiator 102 and the first radiator 101 from top to bottom; the second elastic element is disposed between the second radiator 102 and the second convex portion of the second fixing post, the second elastic element is sleeved on an outer side of the second fixing post and is in a compressed state, and the second convex portion is located above the first convex portion; the PCB 103 is fixed with the second fixing post; a bracket 602 is fixed on a side of the third radiator 601 close to the second radiator 102, and two end portions of the bracket 602 are provided with through holes 604; through the through hole 604 on one end portion of the bracket, one end portion of the bracket 602 is sleeved between the second convex portion and a third convex portion of the first fixing post 105; a third elastic element 603 is disposed between one end portion of the bracket 602 and the third convex portion of the first fixing post 105, and the third elastic element 603 is sleeved on the outer side of the first fixing post 105 and is in a compressed state; the third convex portion of the first fixing post is located above the second convex portion of the first fixing post; through the through hole 604 on the other end portion of the bracket 602, the other end portion of the bracket 602 is sleeved between the second convex portion and a third convex portion of the second fixing post; a fourth elastic element is disposed between the other end portion of the bracket 602 and the third convex portion of the second fixing post, and the fourth elastic element is sleeved on the outer side of the second fixing post and is in a compressed state; and the third convex portion of the second fixing post is located above the second convex portion of the second fixing post. A manner of fixing the third radiator 601 and the bracket 602 is not limited in this embodiment of this application. For example, a heat sink of the third radiator 601 may be fixed with the bracket 602, or a base board of the third radiator 601 may be fixed with the bracket 602; the third radiator 601 and the bracket 602 may be fixed by using a screw, or may be fixed together in a riveted manner or in any other fixing manner; and the third radiator 601 and the bracket 602 may be directly fixed together, or may be fixed together by using another intermediate element.

In the foregoing heat dissipation device, based on that the first radiator and the second radiator are simultaneously fixed by using one group of connecting devices, by sleeving, between the second convex portion and the third convex portion of the fixing post, the through holes on the two end portions of the bracket fixed with the third radiator, and disposing the third elastic element between the bracket and the third convex portion, the same group of connecting devices may be further used, to fix the adjacent second radiator and third radiator, thereby further reducing a quantity of connecting devices, reducing the occupied PCB area, and increasing the area of the heat sink.

In addition, by using the foregoing heat dissipation device, the costs of the heat dissipation device may be further reduced.

Optionally, a heat sink exists above or below the bracket 602.

A heat sink disposed above or below the bracket is not specifically limited in this embodiment of this application. For example, the heat sink may be a part that is of the third radiator 601 and that extends to the second radiator 102, or may be a heat sink of the second radiator 102, or may be a heat sink extending from the first radiator 101, or may be allocated based on a heat dissipation requirement.

In the foregoing heat dissipation device, the heat sink belonging to the first radiator or the second radiator or the third radiator is disposed above or below the bracket, thereby further increasing the area of the heat sink.

Optionally, after other parts of the heat dissipation device are assembled, the heat sink existing above or below the bracket 602 may be welded to the base board of the radiator. Therefore, the solution in this embodiment of this application is easily implemented. Optionally, the bracket 602 may be fastened to the third radiator 601 after separate processing.

Optionally, the bracket 602 and the third radiator 601 may be integrally machined and formed.

Optionally, the first fixing post 105 may be integrally machined and formed.

Optionally, the third convex portion 605 of the first fixing post 105 and a part between the third convex portion 605 and the second convex portion 501, a second convex portion 501 and a part below the second convex portion 501 may be processed separately into a double thread suspension form.

For example, an external screw thread is processed on a lower end of the part between the third convex portion 605 and the second convex portion 501, and an internal screw thread is processed in the second convex portion. The external screw thread and the internal screw thread are fastened together by screwing the external screw thread into the internal screw thread.

Optionally, the first convex portion, the second convex portion and the third convex portion may be a screw nut, a retaining ring, or a downward concave shape (the first elastic element 106 comes into contact with an inner side of the convex shape). A shape of the bracket 602 is not limited in this embodiment of this application, for example, the bracket 602 may be flat, or may be bent.

Optionally, the bracket 602 includes two first cross plates, a second cross plate and two upright plates, where the two first cross plates are respectively on the two end portions of the bracket 602 and both disposed above the second cross plate, and the two upright plates are separately disposed between the two first cross plates and the second cross plate; the third radiator 601 is fixed with the second cross plate; and the through hole 604 is disposed on the first cross plate.

The first cross plates, the second cross plate and the first upright plates in the foregoing heat dissipation device are combined into a concave bracket. By using the concave bracket, a heat sink extends from above the concave shape, thereby further increasing the area of the heat sink.

It should be understood that the bracket 602 is not limited to the shapes described above. For example, the bracket may include two first cross plates and two upright plates, but without a second cross plate. In this case, the two upright plates may be fixed on the third radiator. In this case, the bracket and the third radiator may be integrally formed. Optionally, the bracket 602 in this embodiment of this application may alternatively be fixed only with the first connecting device 109.

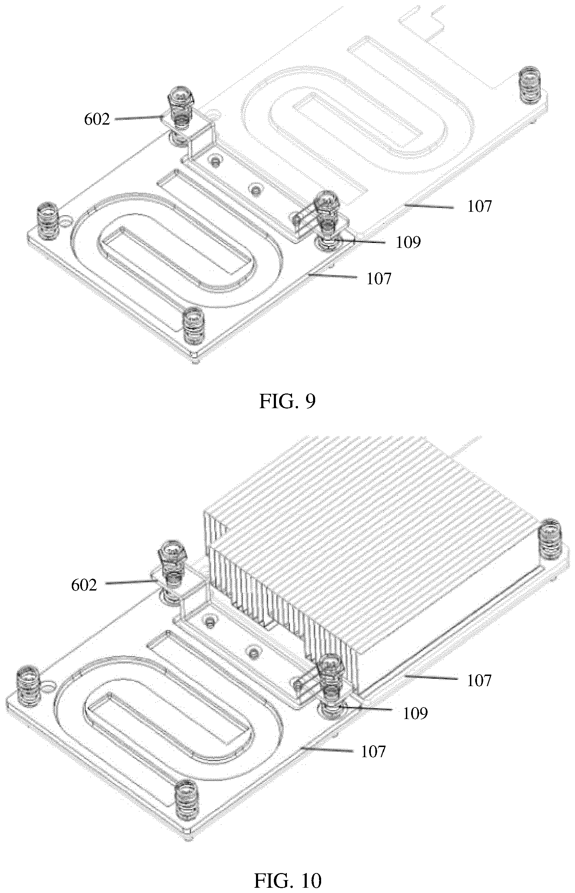

Specifically, the bracket 602 is fixed on the third radiator 601, one end of the bracket 602 is provided with the first through hole 604, the bracket 602 is sleeved between the second convex portion 501 and the third convex portion 605 of the first fixing post 105 through the first through hole 604, and the third convex portion 605 is located above the second convex portion 501; the third elastic element 603 is disposed between the bracket 602 and the third convex portion 605, the third elastic element 603 is sleeved on an outer side of the first fixing post 105 and is in a compressed state; and a heat sink (not shown in FIG. 6, refer to FIG. 10) belonging to the first radiator 101 or the second radiator 102 or the third radiator 601 is disposed above or below the bracket 602.

In the foregoing heat dissipation device, based on that the first radiator and second radiator are fixed by using one group of connecting devices, by sleeving, between the second convex portion and the third convex portion of the first fixing post, the through holes on one end of the bracket fixed with the third radiator and disposing the third elastic element between the bracket and the third convex portion, the same group of connecting devices may be further used, to fix the adjacent second radiator and third radiator, thereby further reducing a quantity of connecting devices, reducing the occupied PCB area, and increasing the area of the heat sink. In addition, the heat sink belonging to the first radiator or the second radiator or the third radiator is disposed above or below the bracket, thereby further increasing the area of the heat sink.

In addition, by using the foregoing heat dissipation device, the costs of the heat dissipation device may be further reduced.

Optionally, the bracket 602 includes a first cross plate, a second cross plate and a first upright plate, where the first cross plate is disposed above the second cross plate, and the first upright plate is disposed between the first cross plate and the second cross plate; the third radiator is fixed with the second cross plate; and the first cross plate is provided with the first through hole. It should be understood that the bracket 602 may not be provided with a second cross plate. In this case, the first upright plate may be fixed with the third radiator. In this case, the bracket 602 and the third radiator may be integrally formed.

The first cross plate, the second cross plate and the first upright plate in the foregoing heat dissipation device are combined into a concave bracket. By using the concave bracket, a heat sink extends from above the concave shape, thereby further increasing the area of the heat sink.

Optionally, the bracket 602 further includes a third cross plate, and a second upright plate is disposed between the third cross plate and the second cross plate; the third cross plate is provided with a second through hole, the bracket 602 is sleeved on a third fixing post through the second through hole, the third fixing post is fixed with the PCB, a fifth elastic element is disposed between a convex portion of the third fixing post and the third cross plate, and the fifth elastic element is sleeved on an outer side of the third fixing post and is in a compressed state.

On the two ends of the fixed bracket of the heat dissipation device, the elastic element may be enabled to produce a uniform force on the bracket.

The third fixing post is not specifically limited in this embodiment of this application, for example, may be an ordinary screw, or may be the connecting device in this embodiment of this application.

A staggered manner of the second radiator 102 and the third radiator 601 is not limited in this embodiment of this application.

Optionally, as shown in FIG. 8, an edge part of the base board of the second radiator 102 is provided with an inward groove, and the base board of the third radiator 601 extends into the groove; and a part that is of the base board of the third radiator and that extends into the groove is fixed with the bracket 602.

Optionally, an upper surface of the edge part of the base board of the second radiator 102 is provided with a groove, and the base board of the third radiator 601 extends into the groove; and a part that is of the base board of the third radiator 601 and that extends into the groove is fixed with the bracket 602.

In the foregoing heat dissipation device, the base board of the second radiator and the base board of the third radiator are placed in a staggered manner, and the bracket is fixed at a location at which the base boards are staggered. One group of connecting devices may be used, to fix the second radiator and the third radiator without affecting heights of the radiators.

A shape of a staggered part of the second radiator 102 and the third radiator 601 is not limited in this embodiment of this application, for example, the staggered part may be square, triangular, or the like.

Optionally, the first radiator 101 is fixed with a convex portion of the first fixing post 104 in a riveted manner.

In the foregoing heat dissipation device, the first radiator and the fixing pipe are connected in a conventional connecting manner. The solution is easily implemented. In a possible implementation, a fixing plate is disposed below the PCB 103, the fixing plate is fixed with the PCB 103, and the first fixing post 105 runs through the PCB 103, and is fixedly connected to the fixing plate in a threaded connection manner.

It should be understood that, in FIG. 7, only the first connecting device 109 is used as an example for description. A connection relationship between the second connecting device 609 and the first radiator 101, the second radiator 102, and the third radiator 601, and a structural feature of the second connecting device 609 are similar to those of the first connecting device 109. Refer to related descriptions of the first connecting device 109, and details are not described herein again. For example, the adjacent main chips are provided with the heat sink 108 and the floating base board 107 respectively, and the two are connected by the heat pipe 301 to implement average temperature heat dissipation in a high power consumption cascade state. The bracket 602 is fastened with the floating base board 107; the fixing post 105 runs through the first elastic element 106 and the third elastic element 603; the third elastic element 603 acts on the bracket 602, and is transferred to the main chip through the floating base board 107; the first elastic element 106 is transferred to the main chip through the floating base board 107; and to prevent mutual influence between the two elastic elements, the second convex portion 501 (for example, a structure that can be locked with a screw, such as a retaining ring, a screw nut, a groove, or the like) is designed on the fixing post 105 to transfer a spring force to a fastening device (for example, a protection plate, not shown) on a lower side of the radiator through the first fixing post 105.

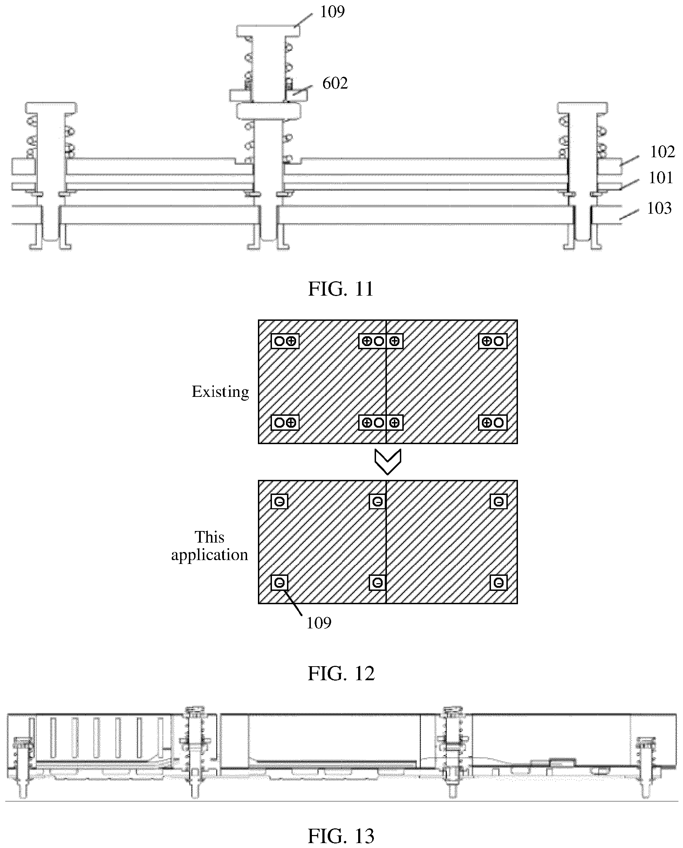

In the foregoing heat dissipation device, the connecting device between the two second radiators is combined into a double-layer spring screw structure. The radiator area occupied by the screw hole site is reduced by 3/4, the occupied PCB hole site is reduced by 1/4, and a schematic diagram of a space avoiding the fasteners is shown in FIG. 12. With reference to FIG. 6 to FIG. 12 above, the two conjoined floating radiators are used as an example for description of a fastening manner of layered screws in this embodiment. It should be understood that, in this embodiment of this application, alternatively, more or fewer main chips may share a conjoined floating radiator. This is not specifically limited. A fastening manner of a shared conjoined floating radiator among three or more main chips is similar to the fastening manner of the foregoing two conjoined floating radiators. For intuitive expression, a fastening manner of the conjoined floating radiator of the three main chips is shown in FIG. 13.

It should be understood that only a double-layer structure is used as an example in this embodiment of this application, and does not constitute a limitation to this application, for example, the structure may alternatively be a three-layer structure or structure of more layers.

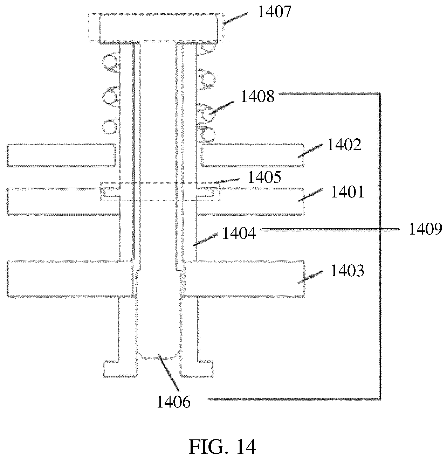

With reference to FIG. 14 to FIG. 17, a structure of another heat dissipation device according to an embodiment of this application is described.

FIG. 14 is a schematic structural diagram of another heat dissipation device according to an embodiment of this application. The heat dissipation device includes a first radiator 1401, a second radiator 1402 and a first connecting device 1409, where the first radiator 1401 and the second radiator 1402 are fastened on a printed circuit board PCB 1403 through the first connecting device 1409; the first radiator 1401 is disposed above a first electronic device, and the second radiator 1402 is disposed above a second electronic device; the first electronic device and the second electronic device are fixed on the PCB 1403; the first connecting device 1409 includes a first fixing pipe 1404, a first fixing post 1406 and a first elastic element 1408; the first radiator 1401 is fixed with the first fixing pipe 1404 through a first convex portion 1405 of the first fixing pipe 1404; the first fixing post 1406 is sleeved in the first fixing pipe 1404, an upper surface of the first fixing pipe 1404 abuts against a lower surface of a convex portion 1407 of the first fixing post 1406, and a lower surface of the first fixing pipe 1404 abuts against an upper surface of the PCB 1403; the first fixing pipe 1404 and the first fixing post 1406 run through the second radiator 1402 and the first radiator 1401 from top to bottom; a first elastic element 1408 is disposed between the second radiator 1402 and the convex portion 1407 of the first fixing post 1406, and the first elastic element 1408 is sleeved on an outer side of the first fixing post 1406 and is in a compressed state; and the PCB 1403 is fixed with the first fixing post 1406.

Optionally, the first radiator 1401 may be a shared bracket, with a gap at a corresponding location of the second radiator for placing the second radiator 1402.

A shape of the gap in the shared bracket is not limited in this embodiment of this application, and may be, for example, a square shape, a round shape, a hexagon shape, or the like.

Specifically, a specific shape of the gap may be determined based on a shape, a production process, or another requirement of a chip on which heat dissipation needs to be performed.

A manner of fixing of the first radiator 1401 and the first fixing post 1406 is not limited in this embodiment of this application. For example, the first radiator 1401 and the first fixing post 1406 may be fixed in a riveted manner, a threaded connection manner, or any other appropriate fixing manner.

A shape of the first fixing pipe 1404 is not limited in this embodiment of this application, for example, the first fixing pipe 104 may be a round pipe, a square pipe, a hexagon tube, or the like.

Optionally, the first fixing pipe 1404 may be a riveting column.

Optionally, the first fixing pipe 1404 and the first fixing post 1406 may be connected through the screw thread 110. The screw thread 110 may include an external screw thread disposed on the first fixing post 1406 and an internal screw thread disposed in the first fixing pipe 1404.

In this solution, the first fixing pipe 1404 is sleeved on the fixing post 1406 in a threaded connection manner, so that during mounting, the first radiator 1401 and the second radiator 1402 can be first fixedly connected, and then the first radiator 1401 and the second radiator 1402 after fixed connection are connected to the PCB 1403. This mounting manner is easily implemented.

Optionally, the first fixing pipe 1404 matches the first fixing post 1406, for example, they are both round.

A shape of the first fixing post 1406 is not limited in this embodiment of this application, for example, the first fixing post 1406 may be a circular column, a square column, a hexagonal column, or the like.

Optionally, the first fixing post 1406 may be a screw or a screw bolt.

Optionally, the first convex portion 1405 of the first fixing pipe may be a sheet that encircles the fixing post 1404.

A shape of the sheet is not limited in this embodiment of this application, for example, the shape of the sheet may be round, square, hexagonal, zigzag, or the like. Optionally, the first convex portion 1405 of the first fixing pipe and the first fixing pipe 1404 may be integrally processed and formed.

Optionally, the first convex portion 1405 of the first fixing pipe and the first fixing pipe 1404 may be assembled and fixed together.

Optionally, the convex portion 1407 of the first fixing post 1406 and the first fixing post may be integrally processed and formed.

A manner of integral processing is used to facilitate processing and production of the first fixing post 1406.

Optionally, the convex portion 1407 of the first fixing post 1406 and the first fixing post 1406 may be assembled and fixed together.

By using a manner of assembling and fixation, use of the first fixing post 1406 may be more flexible.

Optionally, the convex portion 1407 of the first fixing post 1406 may be a screw cap of a screw.

Optionally, the first elastic element may be a spring.

It should be understood that descriptions such as above, upper surface, lower surface, and the like in this embodiment of this application are described only as relative directions, and should not be understood as being the absolute above, upper surface, lower surface, and the like. For example, directions of the first electronic device and the second electronic device may be seen as the above, the upper surface, the lower surface, or the like of a reference direction. As the directions of the first electronic device and the second electronic device are different, the above, the upper surface, and the lower surface may also change accordingly.

In the foregoing heat dissipation device, the fixing post is fixed with the PCB, and the fixing pipe is pressed through the fixing post. The first convex portion of the fixing pipe is fixed with the first radiator, so that the first radiator is fixed. The first elastic element is disposed between the convex portion of the fixing post and the second radiator. The second radiator is fixed by compressing the first elastic element to exert force on the second radiator. In this way, in the heat dissipation device, the connecting device may be used, to fix the first radiator and the second radiator simultaneously, so that there is no need to fix the first radiator and the second radiator respectively with two groups of independent connecting devices, thereby reducing the occupied PCB area and increasing the area of the heat sink. In addition, because the quantity of connecting devices of the heat dissipation device is reduced, costs of the heat dissipation device may be further reduced.

The technical solution of this application is further described below by using a fastening manner of a shared separate floating radiator as an example.

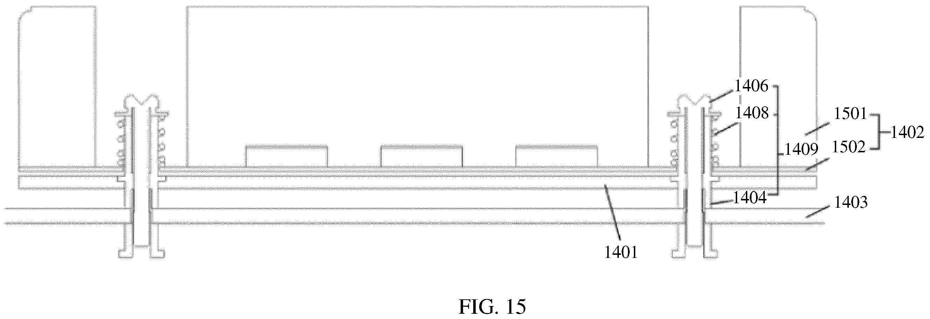

FIG. 15 is a schematic structural diagram of another shared separate floating radiator according to an embodiment of this application. As shown in FIG. 15, the second radiator 1402 includes a floating base board 1501 and a heat sink 1502; the connecting device 1409 includes the fixing post 1406, the first elastic element 1408 and the fixing pipe 1404; the second radiator 1402 is pre-fastened with the first radiator 1401 through the connecting device 1409; the first radiator 1401 is locked on the surface of the PCB 1403 through the fixing post 1406, the first elastic element 1408 and the fixing pipe 1404 shared with the second radiator 1402; when the main chip (not shown in FIG. 15) comes into contact with a floating base board 2101, the floating base board 1501 is lifted, the first elastic element 1408 is compressed, and the floating base board 1501 is separated from the first radiator 1401. In this case, force exerted on the main chip can be accurately controlled by designing a compression amount of the first elastic element 1408. Different from directly pressing the first radiator 1401 by using a step-shaped screw 105, in this embodiment of this application, the fixing post 1406 presses the fixing pipe 1404 to press the first radiator 1401, thereby implementing heat dissipation of peripheral devices (not shown in FIG. 15) tightly close to the first radiator 1401.

In the heat dissipation device, the connecting devices of the second radiator and the connecting devices of the first radiator are integrated into one group of connecting devices, and the fasteners are optimized as a total of 12 fasteners of three types: the fixing post 1406, the first elastic element 1408, and the fixing pipe 1404. A radiator area occupied by hole sites is reduced by approximately 1/2. A space avoiding the fasteners is similar to that shown in FIG. 2. Refer to FIG. 2, and details are not described herein again.

The fastening manner of the shared conjoined floating radiator in this embodiment of this application is similar to the fastening manner shown in FIG. 3, and details are not described herein again.

It should be understood that an application scenario in this embodiment of this application is not limited to a separate floating radiator and a conjoined floating radiator, and can also be applied to all floating radiators.

It should be further understood that in this embodiment of this application, alternatively, more or fewer main chips may further share a conjoined floating radiator. This is not limited in this application.

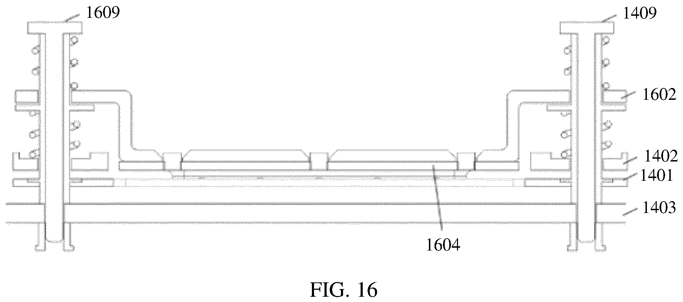

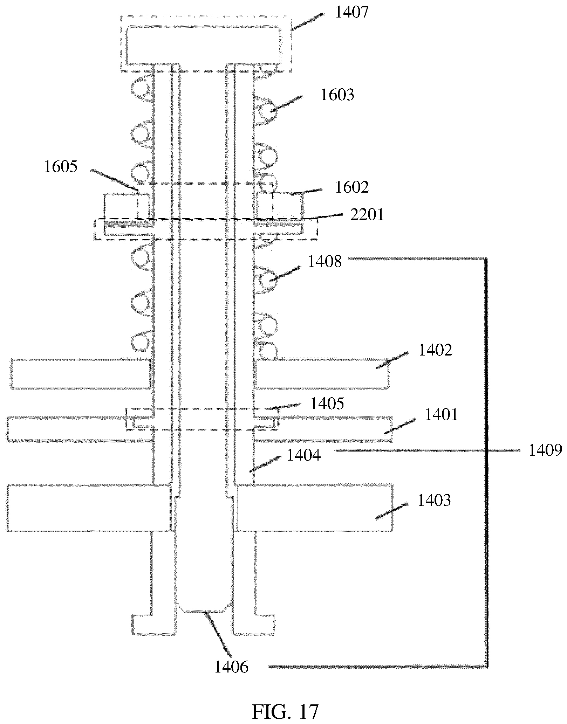

FIG. 16 and FIG. 17 are schematic structural diagrams of another heat dissipation device according to an embodiment of this application. As shown in FIG. 16, the heat dissipation device further includes a third radiator 1604, and the third radiator 1604 is disposed above a third electronic device (not shown in FIG. 16) and is adjacent to the second radiator 1402 in a same plane; the second radiator 1402 and the third radiator 1604 are fastened on the PCB through the first connecting device 1409 and a second connecting device 1609; the second connecting device 1609 includes a second fixing pipe, a second fixing post and a second elastic element; the second radiator 1402 is fixed with the second fixing pipe through a second convex portion of the fixing pipe; the second fixing post is sleeved in the second fixing pipe, an upper surface of the second fixing pipe abuts against a lower surface of a convex portion of the second fixing post, and a lower surface of the second fixing pipe abuts against the upper surface of the PCB 1403; the second fixing pipe and the second post run through the second radiator and the first radiator from top to bottom; the second elastic element is disposed between the second radiator and the convex portion of the second fixing post, the second elastic element is sleeved on an outer side of the second fixing pipe and is in a compressed state, and the PCB 1403 is fixed with the second fixing post; a bracket 1602 is fixed on a side of the third radiator 1604 close to the second radiator, and two end portions of the bracket 1602 are provided with through holes 1605; through the through hole 1605 of one end portion of the bracket, one end portion of the bracket 1602 is sleeved between the second convex portion of the first fixing pipe 1404 and the convex portion of the first fixing post 1406; a third elastic element 1603 is disposed between one end portion of the bracket 1602 and the convex portion of the first fixing post 1406, and the third elastic element 1603 is sleeved on the outer side of the first fixing pipe 1404 and is in a compressed state; the second convex portion of the first fixing pipe is located above the first convex portion of the first fixing pipe; through the through hole 1605 on the other end portion of the bracket 1602, the other end portion of the bracket 1602 is sleeved between the second convex portion of the second fixing pipe and the convex portion of the second fixing post; a fourth elastic element is disposed between the other end portion of the bracket 1602 and the convex portion of the second fixing post, and the fourth elastic element is sleeved on the outer side of the second fixing pipe and is in a compressed state; and the second convex portion of the second fixing pipe is located above the first convex portion of the second fixing pipe. In the foregoing heat dissipation device, based on that the first radiator and the second radiator are simultaneously fixed by using one group of connecting devices, by sleeving, between the second convex portion of the fixing pipe and the convex portion of the fixing post of the connecting device, the through holes on the two end portions of the bracket fixed with the third radiator, where the second convex portion of the fixing pipe and the convex portion of the fixing post of the connecting device are on two ends, and disposing the elastic element between the bracket and the convex portion of the fixing post, the same group of connecting devices may be further used, to fix the adjacent second radiator and third radiator, thereby further reducing a quantity of connecting devices, reducing the occupied PCB area, and increasing the area of the heat sink.

In addition, by using the foregoing heat dissipation device, the costs of the heat dissipation device may be further reduced.

A manner of fixing the third radiator 1604 and the bracket 1602 is not limited in this embodiment of this application. For example, a heat sink of the third radiator 1604 may be fixed with the bracket 1602, or a base board of the third radiator 1604 may be fixed with the bracket 1602; the third radiator 1604 and the bracket 1602 may be fixed by using a screw, or may be fixed together in a riveted manner or in any other fixing manner; and the third radiator 1604 and the bracket 1602 may be directly fixed together, or may be fixed together by using another intermediate element.

Optionally, a heat sink exists above or below the bracket 1602.

A heat sink disposed above or below the bracket 1602 is not specifically limited in this embodiment of this application. For example, the heat sink may be a part that is of the third radiator 1604 and that extends to the second radiator 1402, or may be a heat sink of the second radiator 1402, or may be a heat sink extending from the first radiator 1401, or may be allocated based on a heat dissipation requirement.

In the foregoing heat dissipation device, the heat sink belonging to the first radiator or the second radiator or the third radiator is disposed above or below the bracket, thereby further increasing the area of the heat sink.

Optionally, the bracket 1602 may be fastened to the third radiator 1604 after being separately processed.

Optionally, the bracket 1602 and the third radiator 1604 may be integrally machined and formed.

Optionally, the first fixing pipe 1404 may be integrally machined and formed.

Optionally, the first fixing pipe 1404, the first convex portion 1405 and the second convex portion of the first fixing pipe 1404 may be processed separately, and then be assembled and fixed together.

Optionally, the second convex portion may be a screw nut, a retaining ring, or a downward concave shape (the first elastic element 106 comes into contact with an inner side of the concave shape).

In addition, by using the foregoing heat dissipation device, the costs of the heat dissipation devices may be further reduced.

A shape of the bracket 1602 is not limited in this embodiment of this application, for example, the bracket 1602 may be flat, or may be bent.

Optionally, the bracket 1602 includes two first cross plates, a second cross plate and two upright plates, where the two first cross plates are respectively on the two end portions of the bracket 1602 and both disposed above the second cross plate, and the two upright plates are disposed between the two first cross plates and the second cross plate separately; the third radiator 1604 is fixed with the second cross plate; and the through hole 1605 is disposed on the first cross plate.

The first cross plates, the second cross plate and the first upright plates of the foregoing heat dissipation device are combined into a concave bracket. By using the concave bracket, a heat sink extends from above a concave shape, thereby further increasing the area of the heat sink. Optionally, the heat dissipation device in this embodiment of this application may be fixed only by using the connecting device 1409.

It should be understood that the bracket 1602 is limited to the shapes described above. For example, the bracket may include two first cross plates and two upright plates, but without a second cross plate. In this case, the two upright plates may be fixed on the third radiator. In this case, the bracket and the third radiator may be integrally formed. For example, as shown in FIG. 16, a bracket 1602 is fixed on the third radiator 1604 (not shown in FIG. 16, refer to FIG. 17), a first through hole 1605 is disposed on one end of the bracket 1602, the bracket 1602 is sleeved between a second convex portion the fixing pipe 1404 and the convex portion 1407 of the first fixing post 1406 through the first through hole 1605, and the second convex portion is located above the first convex portion 1405; a second elastic element 1603 is disposed between the bracket 1602 and the convex portion 1407 of the first fixing post 1406, and the second elastic element 1603 is sleeved on the outer side of the fixing pipe 1404 and is in a compressed state; and a heat sink belonging to the first radiator 1401 or the second radiator 1402 or the third radiator 1604 is disposed above or below the bracket 1602.

In the foregoing heat dissipation device, based on that the first radiator and the second radiator are simultaneously fixed by using one group of connecting devices, by sleeving, between the second convex portion and the third convex portion of the first fixing post, the through holes on one end of the bracket fixed with the third radiator, and disposing the second elastic element between the bracket and the third convex portion, the same group of connecting devices may be further used, to fix the adjacent second radiator and third radiator, thereby further reducing a quantity of connecting devices, reducing the occupied PCB area, and increasing the area of the heat sink. In addition, the heat sink belonging to the first radiator or the second radiator or the third radiator is disposed above or below the bracket, thereby further increasing the area of the heat sink.

In addition, by using the foregoing heat dissipation device, the costs of the heat dissipation device may be further reduced.

Optionally, the bracket 1602 includes a first cross plate, a second cross plate and a first upright plate, where the first cross plate is disposed above the second cross plate, and the first upright plate is disposed between the first cross plate and the second cross plate; the third radiator is fixed with the second cross plate; and the first cross plate is provided with the first through hole. It should be understood that the bracket 1602 may not be provided with a second cross plate. In this case, the first upright plate may be fixed with the third radiator. In this case, the bracket 1602 and the third radiator may be integrally formed.

The first cross plate, the second cross plate and the first upright plate of the foregoing heat dissipation device are combined into a concave bracket. By using the concave bracket, a heat sink extends from above a concave shape, thereby further increasing the area of the heat sink.

Optionally, the bracket 1602 may further include a third cross plate, and a second upright plate is disposed between the third cross plate and the second cross plate; the third cross plate is provided with a second through hole, the bracket 1602 is sleeved on the third fixing post through the second through hole, the third fixing post is fixed with the PCB, a fifth elastic element is disposed between the convex portion of the third fixing post and the third cross plate, and the fifth elastic element is sleeved on an outer side of the third fixing post and is in a compressed state.

On the two ends of the fixed bracket of the heat dissipation device, the elastic element may be enabled to produce a uniform force on the bracket. Optionally, an edge part of the base board of the second radiator 1402 is provided with an inward groove, and the base board of the third radiator 1604 extends into the groove; and a part that is of the base board of the third radiator 1604 and that extends into the groove is fixed with the bracket 1602. The structure is similar to the structure shown in FIG. 13. Refer to FIG. 13, and details are not described herein again.

Optionally, an upper surface of the edge part of the base board of the second radiator 1402 is provided with a groove, and the base board of the third radiator 1604 extends into the groove; and a part that is of the base board of the third radiator 1604 and that extends into the groove is fixed with the bracket 1602.

In the foregoing heat dissipation device, the base board of the second radiator and the base board of the third radiator are placed in a staggered manner, and the bracket is fixed at a location at which the base boards are staggered. One group of connecting devices may be used, to fix the second radiator and the third radiator without affecting heights of the radiators.

Optionally, the first radiator 1402 is fixed with the first convex portion 1405 of the first fixing pipe 1404 in a riveted manner.

In the foregoing heat dissipation device, the first radiator and the fixing pipe are connected in a conventional connecting manner. The solution is easily implemented. In a possible implementation, a fixing plate is disposed below the PCB 1403, the fixing plate is fixed with the PCB 1403, and the first fixing post 1406 runs through the PCB 1403 and is fixedly connected to the fixing plate in a threaded connection manner.

It should be understood that in FIG. 17, only the first connecting device 1409 is used as an example for description. A connection relationship between the second connecting device 1609 and the first radiator 1401, the second radiator 1402, and the third radiator 1604, and a structural feature of the second connecting device 1609 are similar to those of the first connecting device 1409. Refer to related descriptions of the first connecting device 1409, and details are not described herein again.

A fastening manner of the shared conjoined floating radiator between the two main chips or between more or fewer main chips in this embodiment of this application is similar to the fastening manners shown in FIG. 9 or FIG. 12. Refer to FIG. 9 to FIG. 12, and details are not described herein again.

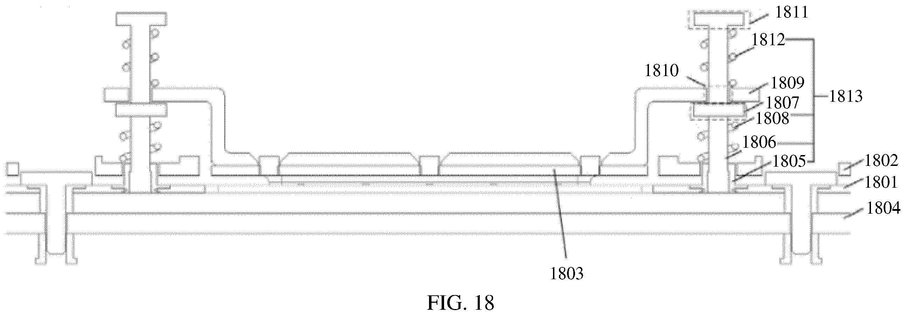

With reference to FIG. 18 to FIG. 20, a structure of another heat dissipation device in this embodiment of this application is described.

FIG. 18 is a schematic structural diagram of another heat dissipation device according to an embodiment of this application. As shown in FIG. 18, the heat dissipation device includes a first radiator 1801, a second radiator 1802, a third radiator 1803 and a connecting device 1813; the second radiator 1802 and the third radiator 1803 are fixedly connected through the connecting device 1813; the connecting device 1813 includes a fixing pipe 1805, a first fixing post 1806, a first elastic element 1808 and a second elastic element 1812; the first radiator 1801 is fixed with the PCB 1804, and fixed with the fixing pipe 1805; the first fixing post 1806 is sleeved in the fixing pipe 1805, an upper surface of the fixing pipe 1805 abuts against a lower surface of a first convex portion 1807 of the first fixing post 1806, and a lower end of the fixing pipe 1805 is fixed with a lower end of the fixing post 1806; a first elastic element 1808 is disposed between the second radiator 1802 and the first convex portion 1807 of the first fixing post 1806, and the first elastic element 1808 is sleeved on an outer side of the first fixing post 1806 and is in a compressed state; a bracket 1809 is fixed on the third radiator 1803, one end of the bracket 1809 is provided with a through hole 1810, through the through hole 1810, the bracket 1806 is sleeved between the first convex portion 1807 of the first fixing post 1806 and a second convex portion 1811 of the first fixing post 1806, and the second convex portion 1811 is located above the first convex portion 1807; a second elastic element 1812 is disposed between the bracket 1809 and the second convex portion 1811 of the first fixing post 1806, and the second elastic element 1812 is sleeved on the outer side of the first fixing post 1806 and is in a compressed state; the first fixing post 1806 runs through the bracket 1809 and the second radiator 1802 from top to bottom; and a heat sink belonging to the first radiator 1801 or the second radiator 1802 or the third radiator 1803 is disposed above or below the bracket 1809.

Optionally, the bracket 1809 includes a first cross plate, a second cross plate and a first upright plate, where the first cross plate is disposed above the second cross plate, and the first upright plate is disposed between the first cross plate and the second cross plate; the third radiator 1803 is fixed with the second cross plate; and the first cross plate is provided with the first through hole 1810. It should be understood that the bracket 1809 may not be provided with a second cross plate. In this case, the first upright plate may be fixed with the third radiator. In this case, the bracket 1809 and the third radiator may be integrally formed.

Optionally, an upper surface of an edge part of a base board of the second radiator 1802 is provided with a groove, and a base board of the third radiator 1803 extends into the groove; and a part that is of the base board of the third radiator 1803 and that extends into the groove is fixed with the bracket 1809.

Optionally, the bracket 1809 further includes a third cross plate, a second upright plate is disposed between the third cross plate and the first cross plate; the third cross plate is provided with a second through hole, the bracket is sleeved on the second fixing post through the second through hole, the second fixing post is fixed with the PCB, a third elastic element is disposed between the convex portion of the second fixing post and the third cross plate, and the third elastic element is sleeved on an outer side of the second fixing post and is in a compressed state.

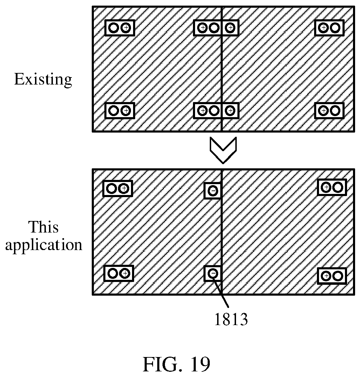

A schematic diagram of a space avoiding the fasteners in this embodiment of this application is shown in FIG. 19.

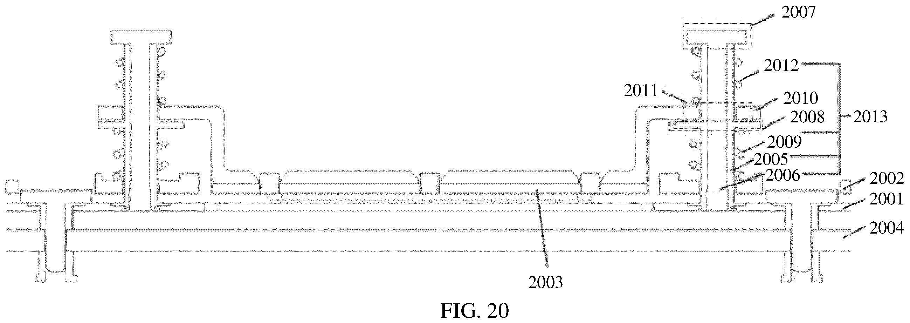

FIG. 20 is a schematic structural diagram of another heat dissipation device according to an embodiment of this application. As shown in FIG. 20, the heat dissipation device includes a first radiator 2001, a second radiator 2002, a third radiator 2003 and a connecting device 2013; the second radiator 2002 and the third radiator 2003 are fixedly connected through the connecting device 2013; the connecting device 2013 includes a fixing pipe 2005, a first fixing post 2006, a first elastic element 2009 and a second elastic element 2012; the first radiator 2001 is fixed with the PCB 2004, and fixed with a lower part the fixing pipe 2005; the first fixing post 2006 is sleeved in the fixing pipe 2005, an upper surface of the fixing pipe 2005 abuts against a lower surface of a convex portion 2007 of the first fixing post 2006, and a lower end of the fixing pipe 2005 is fixed with a lower end of the first fixing post 2006; a first elastic element 2009 is disposed between the second radiator 2002 and a convex portion 2008 of the fixing pipe 2005, and the first elastic element 2009 is sleeved on an outer side of the fixing pipe 2005 and is in a compressed state; a bracket 2010 is fixed on the third radiator 2003, a first through hole 2011 is disposed on one end of the bracket 2010, and the bracket 2010 is sleeved between the convex portion 2008 of the fixing pipe 2005 and the convex portion 2007 of the first fixing post 2006 through the first through hole 2011; a second elastic element 2012 is disposed between the bracket 2010 and the convex portion 2007 of the first fixing post 2006, and the second elastic element 2012 is sleeved on an outer side of the fixing pipe 2005 and is in a compressed state; the fixing pipe 2005 runs through the bracket 2010 and the second radiator 2002 from top to bottom; and a heat sink belonging to the first radiator 2001 or the second radiator 2002 or the third radiator 2003 is disposed above or below the bracket 2010.

Optionally, the bracket 2010 includes a first cross plate, a second cross plate and a first upright plate, where the first cross plate is disposed above the second cross plate, the first upright plate is disposed between the first cross plate and the second cross plate; the third radiator 2003 is fixed with the second cross plate; and the second cross plate is provided with the first through hole 2011. It should be understood that the bracket 2010 may not be provided with a second cross plate. In this case, the first upright plate may be fixed with the third radiator. In this case, the bracket 2010 and the third radiator may be integrally formed.

Optionally, an upper surface of an edge part of a base board of the second radiator 2002 is provided with a groove, and a base board of the third radiator 2003 extends into the groove; and a part that is of the base board of the third radiator 2003 and that extends into the groove is fixed with the bracket 2010.

Optionally, the bracket 2010 further includes a third cross plate, a second upright plate is disposed between the third cross plate and the first cross plate; the third cross plate is provided with a second through hole, the bracket is sleeved on the second fixing post through the second through hole, the second fixing post is fixed with the PCB, a third elastic element is disposed between the convex portion of the second fixing post and the third cross plate, and the third elastic element is sleeved on an outer side of the second fixing post and is in a compressed state.

An embodiment of this application further provides an electronic device, where the electronic device includes a printed circuit board PCB and a heat dissipation device in any possible implementation described above.

The electronic device may be any device including a circuit board, such as a terminal device, a network device, a computer, an air conditioner, a refrigerator, a printer, or a fax machine. This is not specifically limited in this embodiment of this application.

## Claims

1. A heat dissipation device, comprising:
a first radiator (101, 1401, 1801, 2001), a second radiator (102, 1402, 1802, 2002) and a first connecting device (109, 1409), wherein the first radiator (101, 1401, 1801, 2001) and the second radiator (102, 1402, 1802, 2002) are fastened onto a printed circuit board, PCB (103, 1403, 1804, 2004), through the first connecting device (109, 1409);
the first radiator (101, 1401, 1801, 2001) is disposed above a first electronic device, and the second radiator (102, 1402, 1802, 2002) is disposed above a second electronic device; the first electronic device and the second electronic device are fixed on the PCB (103, 1403, 1804, 2004);
the first connecting device (109, 1409) comprises a first fixing pipe (104, 1404), a first fixing post (105, 1404, 1406, 1806, 2006) and a first elastic element (106, 1408, 1808, 2009);
the first radiator (101, 1401, 1801, 2001) is fixed with the first fixing pipe (104, 1404); the first fixing post (105, 1404, 1406, 1806, 2006) is sleeved in the first fixing pipe (104, 1404), an upper surface of the first fixing pipe (104, 1404) abuts against a lower surface of a first convex portion (502, 1405, 1807) of the first fixing post (105, 1404, 1406, 1806, 2006), and a lower surface of the first fixing pipe (104, 1404) abuts against an upper surface of the PCB (103, 1403, 1804, 2004); the first fixing post (105, 1404, 1406, 1806, 2006) runs through the second radiator (102, 1402, 1802, 2002) and the first radiator (101, 1401, 1801, 2001) from top to bottom;
the first elastic element (106, 1408, 1808, 2009) is disposed between the second radiator (102, 1402, 1802, 2002) and a second convex portion (501, 1601, 1811) of the first fixing post (105, 1404, 1406, 1806, 2006), the first elastic element (106, 1408, 1808, 2009) is sleeved on an outer side of the first fixing post (105, 1404, 1406, 1806, 2006) and is in a compressed state, and the second convex portion (501, 1601, 1811) is located above the first convex portion (502, 1405, 1807) of the first fixing post; and
the PCB (103, 1403, 1804, 2004) is fixed with the first fixing post (105, 1404, 1406, 1806, 2006);
**characterized in that**
the heat dissipation device further comprises a third radiator (601, 1604, 1803, 2003), and the third radiator (601, 1604, 1803, 2003) is disposed above a third electronic device and is adjacent to the second radiator (102, 1402, 1802, 2002) in a same plane; the second radiator (102, 1402, 1802, 2002) and the third radiator (601, 1604, 1803, 2003) are fastened on the PCB (103, 1403, 1804, 2004) through the first connecting device (109, 1409) and a second connecting device (609, 1609);
the second connecting device (609, 1609) comprises a second fixing pipe, a second fixing post and a second elastic element (1603, 1812, 2012);
the second radiator (102, 1402, 1802, 2002) is fixed with the second fixing pipe; the second fixing post is sleeved in the second fixing pipe, an upper surface of the second fixing pipe abuts against a lower surface of a second convex portion (501, 1601, 1811) of the second fixing post, and a lower surface of the second fixing pipe abuts against the upper surface of the PCB (103, 1403, 1804, 2004); the second fixing post runs through the second radiator (102, 1402, 1802, 2002) and the first radiator (101, 1401, 1801, 2001) from top to bottom;
the second elastic element (1603, 1812, 2012) is disposed between the second radiator (102, 1402, 1802, 2002) and the second convex portion (501, 1601, 1811) of the second fixing post, the second elastic element (1603, 1812, 2012) is sleeved on an outer side of the second fixing post and is in a compressed state, and the second convex portion (501, 1601, 1811) is located above the first convex portion (502, 1405, 1807) of the first fixing post; the PCB (103, 1403, 1804, 2004) is fixed with the second fixing post.

2. The heat dissipation device according to claim 1, wherein the heat dissipation device further comprises
a bracket (602, 1602, 1809, 2010) is fixed on a side of the third radiator (601, 1604, 1803, 2003) close to the second radiator (102, 1402, 1802, 2002), and two end portions of the bracket (602, 1602, 1809, 2010) are provided with through holes (604, 1605, 1810, 2011);
through the through hole (604, 1605, 1810, 2011) on one end portion of the bracket (602, 1602, 1809, 2010), one end portion of the bracket (602, 1602, 1809, 2010) is sleeved between the second convex portion (501, 1601, 1811) and a third convex portion (603) of the first fixing post (105, 1404, 1406, 1806, 2006); a third elastic element (603, 1603) is disposed between one end portion of the bracket (602, 1602, 1809, 2010) and the third convex portion (603) of the first fixing post (105, 1404, 1406, 1806, 2006), and the elastic element is sleeved on the outer side of the first fixing post (105, 1404, 1406, 1806, 2006) and is in a compressed state; the third convex portion (603) of the first fixing post (105, 1404, 1406, 1806, 2006) is located above the second convex portion (501, 1601, 1811) of the first fixing post (105, 1404, 1406, 1806, 2006); and
through the through hole (604, 1605, 1810, 2011) on the other end portion of the bracket (602, 1602, 1809, 2010), the other end portion of the bracket (602, 1602, 1809, 2010) is sleeved between the second convex portion (501, 1601, 1811) and a third convex portion (603) of the second fixing post; a fourth elastic element is disposed between the other end portion of the bracket (602, 1602, 1809, 2010) and the third convex portion (603) of the second fixing post, and the fourth elastic element is sleeved on the outer side of the second fixing post and is in a compressed state; and the third convex portion (603) of the second fixing post is located above the second convex portion (501, 1601, 1811) of the second fixing post.

3. The heat dissipation device according to claim 2, wherein the bracket (602, 1602, 1809, 2010) comprises two first cross plates, a second cross plate and two upright plates, wherein the two first cross plates are respectively on the two end portions of the bracket (602, 1602, 1809, 2010) and both disposed above the second cross plate, and the two upright plates are separately disposed between the two cross plates and the second cross plate;
the third radiator (601, 1604, 1803, 2003) is fixed with the second cross plate; and
the first cross plate is provided with the through holes (604, 1605, 1810, 2011).

4. The heat dissipation device according to claim 2 or 3, wherein an upper surface of an edge part of a base board (107, 1501, 2101) of the second radiator (102, 1402, 1802, 2002) is provided with a groove, and a base board (107, 1501, 2101) of the third radiator (601, 1604, 1803, 2003) extends into the groove; and
a part that is of the base board (107, 1501, 2101) of the third radiator (601, 1604, 1803, 2003) and that extends into the groove is fixed with the bracket (602, 1602, 1809, 2010).

5. The heat dissipation device according to any one of claims 2 to 4, wherein a heat sink exists above or below the bracket (602, 1602, 1809, 2010).

6. The heat dissipation device according to any one of claims 1 to 5, wherein
a radius that is of a part of the first fixing post (105, 1404, 1406, 1806, 2006) and that is above the upper surface of the fixing pipe (104, 1404) is greater than a radius of a part that is of the first fixing post (105, 1404, 1406, 1806, 2006) and that is below the upper surface of the fixing pipe (104, 1404); and the first convex portion (502, 1405, 1807) of the first fixing post (105, 1404, 1406, 1806, 2006) is a part that is of the first fixing post (105, 1404, 1406, 1806, 2006) and that is between the second convex portion (501, 1601, 1811) of the first fixing post (105, 1404, 1406, 1806, 2006) and the upper surface of the first fixing pipe (104, 1404).

7. The heat dissipation device according to any one of claims 1 to 6, wherein the first fixing post (105, 1404, 1406, 1806, 2006) is sleeved in the first fixing pipe (104, 1404) in a threaded connection manner.

8. The heat dissipation device according to any one of claims 1 to 7, wherein the first radiator (101, 1401, 1801, 2001) is fixed with a convex portion of the first fixing pipe (104, 1404) in a riveted manner.

9. The heat dissipation device according to any one of claims 1 to 8, wherein a fixing plate is disposed below the PCB (103, 1403, 1804, 2004), the fixing plate is fixed with the PCB (103, 1403, 1804, 2004), and the first fixing post (105, 1404, 1406, 1806, 2006) runs through the PCB (103, 1403, 1804, 2004) and is fixedly connected to the fixing plate in a threaded connection manner.

10. A heat dissipation device, comprising:
a first radiator (101, 1401, 1801, 2001), a second radiator (102, 1402, 1802, 2002) and a first connecting device (109, 1409), wherein the first radiator (101, 1401, 1801, 2001) and the second radiator (102, 1402, 1802, 2002) are fastened onto a printed circuit board, PCB (103, 1403, 1804, 2004), through the first connecting device (109, 1409);
the first radiator (101, 1401, 1801, 2001) is disposed above a first electronic device, and the second radiator (102, 1402, 1802, 2002) is disposed above a second electronic device; the first electronic device and the second electronic device are fixed on the PCB (103, 1403, 1804, 2004);
the first connecting device (109, 1409) comprises a first fixing pipe (104, 1404), a first fixing post (105, 1404, 1406, 1806, 2006) and a first elastic element (106, 1408, 1808, 2009);
the first radiator (101, 1401, 1801, 2001) is fixed with the first fixing pipe (104, 1404) through a first convex portion (502, 1405, 1807) of the first fixing pipe; the first fixing post (105, 1404, 1406, 1806, 2006) is sleeved in the first fixing pipe (104, 1404), an upper surface of the first fixing pipe (104, 1404) abuts against a lower surface of a convex portion of the first fixing post (105, 1404, 1406, 1806, 2006), and a lower surface of the first fixing pipe (104, 1404) abuts against an upper surface of the PCB (103, 1403, 1804, 2004);
the first fixing pipe (104, 1404) and the first fixing post (105, 1404, 1406, 1806, 2006) run through the second radiator (102, 1402, 1802, 2002) and the first radiator (101, 1401, 1801, 2001) from top to bottom;
the first elastic element (106, 1408, 1808, 2009) is disposed between the second radiator (102, 1402, 1802, 2002) and the convex portion of the fixing post, and the first elastic element (106, 1408, 1808, 2009) is sleeved on an outer side of the first fixing pipe (104, 1404) and is in a compressed state; and
the PCB (103, 1403, 1804, 2004) is fixed with the first fixing post (105, 1404, 1406, 1806, 2006);
**characterized in that**
the heat dissipation device further comprises a third radiator (601, 1604, 1803, 2003), and the third radiator (601, 1604, 1803, 2003) is disposed above a third electronic device and is adjacent to the second radiator (102, 1402, 1802, 2002) in a same plane; the second radiator (102, 1402, 1802, 2002) and the third radiator (601, 1604, 1803, 2003) are fastened on the PCB (103, 1403, 1804, 2004) through the first connecting device (109, 1409) and a second connecting device (609, 1609);
the second connecting device (609, 1609) comprises a second fixing pipe, a second fixing post and a second elastic element (1603, 1812, 2012);
the second radiator (102, 1402, 1802, 2002) is fixed with the second fixing pipe through a second convex portion (501, 1601, 1811) of the second fixing pipe; the second fixing post is sleeved in the second fixing pipe, an upper surface of the second fixing pipe abuts against a lower surface of a convex portion of the second fixing post, and a lower surface of the second fixing pipe abuts against the upper surface of the PCB (103, 1403, 1804, 2004);
the second fixing pipe and the second fixing post run through the second radiator (102, 1402, 1802, 2002) and the first radiator (101, 1401, 1801, 2001) from top to bottom;
the second elastic element (1603, 1812, 2012) is disposed between the second radiator (102, 1402, 1802, 2002) and the convex portion of the second fixing post, and the second elastic element (1603, 1812, 2012) is sleeved on an outer side of the second fixing pipe and is in a compressed state;
the PCB (103, 1403, 1804, 2004) is fixed with the second fixing post.

11. The heat dissipation device according to claim 10, wherein the heat dissipation device further comprises:
a bracket (602, 1602, 1809, 2010) is fixed on a side of the third radiator (601, 1604, 1803, 2003) close to the second radiator (102, 1402, 1802, 2002), and two end portions of the bracket (602, 1602, 1809, 2010) are provided with through holes (604, 1605, 1810, 2011);
through the through hole (604, 1605, 1810, 2011) of one end portion of the bracket (602, 1602, 1809, 2010), one end portion of the bracket (602, 1602, 1809, 2010) is sleeved between a second convex portion (501, 1601, 1811) of the first fixing pipe (104, 1404) and the convex portion of the first fixing post (105, 1404, 1406, 1806, 2006); a third elastic element (603, 1603) is disposed between one end portion of the bracket (602, 1602, 1809, 2010) and the convex portion of the first fixing post (105, 1404, 1406, 1806, 2006), and the elastic element is sleeved on the outer side of the first fixing post (105, 1404, 1406, 1806, 2006) and is in a compressed state; the second convex portion (501, 1601, 1811) of the first fixing pipe (104, 1404) is located above the first convex portion (502, 1405, 1807) of the first fixing pipe (104, 1404); and
through the through hole (604, 1605, 1810, 2011) on the other end portion of the bracket (602, 1602, 1809, 2010), the other end portion of the bracket (602, 1602, 1809, 2010) is sleeved between the second convex portion (501, 1601, 1811) of the second fixing pipe and the convex portion of the second fixing post; a fourth elastic element is disposed between the other end portion of the bracket (602, 1602, 1809, 2010) and the convex portion of the second fixing post, and the fourth elastic element is sleeved on the outer side of the second fixing pipe and is in a compressed state; and the second convex portion (501, 1601, 1811) of the second fixing pipe is located above a first convex portion (502, 1405, 1807) of the second fixing pipe.

12. An electronic device, comprising a printed circuit board, PCB (103, 1403, 1804, 2004), wherein the heat dissipation device according to any one of claims 1 to 9 is disposed on the PCB (103, 1403, 1804, 2004).

13. An electronic device, comprising a printed circuit board, PCB (103, 1403, 1804, 2004), wherein the heat dissipation device according to claim 10 or 11 is disposed on the PCB (103, 1403, 1804, 2004).

## Patentansprüche

1. Wärmeableitungsvorrichtung, umfassend:
einen ersten Radiator (101, 1401, 1801, 2001), einen zweiten Radiator (102, 1402, 1802, 2002) und eine erste Verbindungsvorrichtung (109, 1409), wobei der erste Radiator (101, 1401, 1801, 2001) und der zweite Radiator (102, 1402, 1802, 2002) auf einer Leiterplatte, PCB (103, 1403, 1804, 2004), durch die erste Verbindungsvorrichtung (109, 1409) angebracht sind;
wobei der erste Radiator (101, 1401, 1801, 2001) über einer ersten elektronischen Vorrichtung angeordnet ist und der zweite Radiator (102, 1402, 1802, 2002) über einer zweiten elektronischen Vorrichtung angeordnet ist; wobei die erste elektronische Vorrichtung und die zweite elektronische Vorrichtung an der PCB (103, 1403, 1804, 2004) befestigt sind;
wobei die erste Verbindungsvorrichtung (109, 1409) ein erstes Befestigungsrohr (104, 1404), einen ersten Befestigungspfosten (105, 1404, 1406, 1806, 2006) und ein erstes elastisches Element (106, 1408, 1808, 2009) umfasst;
wobei der erste Radiator (101, 1401, 1801, 2001) mit dem ersten Befestigungsrohr (104, 1404) befestigt ist; wobei der erste Befestigungspfosten (105, 1404, 1406, 1806, 2006) in das erste Befestigungsrohr (104, 1404) geschoben ist, wobei eine obere Fläche des ersten Befestigungsrohrs (104, 1404) an einer unteren Fläche eines ersten konvexen Abschnitts (502, 1405, 1807) des ersten Befestigungspfostens (105, 1404, 1406, 1806, 2006) anliegt und eine untere Fläche des ersten Befestigungsrohrs (104, 1404) an einer oberen Fläche der PCB (103, 1403, 1804, 2004) anliegt; wobei der erste Befestigungspfosten (105, 1404, 1406, 1806, 2006) durch den zweiten Radiator (102, 1402, 1802, 2002) und den ersten Radiator (101, 1401, 1801, 2001) von oben nach unten verläuft;
wobei das erste elastische Element (106, 1408, 1808, 2009) zwischen dem zweiten Radiator (102, 1402, 1802, 2002) und einem zweiten konvexen Abschnitt (501, 1601, 1811) des ersten Befestigungspfostens (105, 1404, 1406, 1806, 2006) angeordnet ist, wobei das erste elastische Element (106, 1408, 1808, 2009) auf eine Außenseite des ersten Befestigungspfostens (105, 1404, 1406, 1806, 2006) geschoben ist und sich in einem komprimierten Zustand befindet, und wobei sich der zweite konvexe Abschnitt (501, 1601, 1811) über dem ersten konvexen Abschnitt (502, 1405, 1807) des ersten Befestigungspfostens befindet; und
wobei die PCB (103, 1403, 1804, 2004) mit dem ersten Befestigungspfosten (105, 1404, 1406, 1806, 2006) befestigt ist;
**dadurch gekennzeichnet, dass**
die Wärmeableitungsvorrichtung ferner einen dritten Radiator (601, 1604, 1803, 2003) umfasst und der dritte Radiator (601, 1604, 1803, 2003) über einer dritten elektronischen Vorrichtung angeordnet ist und an den zweiten Radiator (102, 1402, 1802, 2002) in einer selben Ebene angrenzt; wobei der zweite Radiator (102, 1402, 1802, 2002) und der dritte Radiator (601, 1604, 1803, 2003) an der PCB (103, 1403, 1804, 2004) durch die erste Verbindungsvorrichtung (109, 1409) und eine zweite Verbindungsvorrichtung (609, 1609) angebracht sind;
die zweite Verbindungsvorrichtung (609, 1609) ein zweites Befestigungsrohr, einen zweiten Befestigungspfosten und ein zweites elastisches Element (1603, 1812, 2012) umfasst;
der zweite Radiator (102, 1402, 1802, 2002) mit dem zweiten Befestigungsrohr befestigt ist; wobei der zweite Befestigungspfosten in das zweite Befestigungsrohr geschoben ist, wobei eine obere Fläche des zweiten Befestigungsrohrs an einer unteren Fläche eines zweiten konvexen Abschnitts (501, 1601, 1811) des zweiten Befestigungspfostens anliegt und eine untere Fläche des zweiten Befestigungsrohrs an der oberen Fläche der PCB (103, 1403, 1804, 2004) anliegt; wobei der zweite Befestigungspfosten durch den zweiten Radiator (102, 1402, 1802, 2002) und den ersten Radiator (101, 1401, 1801, 2001) von oben nach unten verläuft;
das zweite elastische Element (1603, 1812, 2012) zwischen dem zweiten Radiator (102, 1402, 1802, 2002) und dem zweiten konvexen Abschnitt (501, 1601, 1811) des zweiten Befestigungspfostens angeordnet ist, wobei das zweite elastische Element (1603, 1812, 2012) auf eine Außenseite des zweiten Befestigungspfostens geschoben ist und sich in einem komprimierten Zustand befindet, und wobei sich der zweite konvexe Abschnitt (501, 1601, 1811) über dem ersten konvexen Abschnitt (502, 1405, 1807) des ersten Befestigungspfostens befindet; wobei die PCB (103, 1403, 1804, 2004) mit dem zweiten Befestigungspfosten befestigt ist.

2. Wärmeableitungsvorrichtung nach Anspruch 1, wobei die Wärmeableitungsvorrichtung ferner Folgendes umfasst
ein Bügel (602, 1602, 1809, 2010) ist an einer Seite des dritten Radiators (601, 1604, 1803, 2003) in der Nähe des zweiten Radiators (102, 1402, 1802, 2002) befestigt und zwei Endabschnitte des Bügels (602, 1602, 1809, 2010) sind mit Durchgangslöchern (604, 1605, 1810, 2011) versehen;
durch das Durchgangsloch (604, 1605, 1810, 2011) an einem Endabschnitt des Bügels (602, 1602, 1809, 2010) ist ein Endabschnitt des Bügels (602, 1602, 1809, 2010) zwischen den zweiten konvexen Abschnitt (501, 1601, 1811) und einen dritten konvexen Abschnitt (603) des ersten Befestigungspfostens (105, 1404, 1406, 1806, 2006) geschoben; wobei ein drittes elastisches Element (603, 1603) zwischen einem Endabschnitt des Bügels (602, 1602, 1809, 2010) und dem dritten konvexen Abschnitt (603) des ersten Befestigungspfostens (105, 1404, 1406, 1806, 2006) angeordnet ist und das elastische Element auf die Außenseite des ersten Befestigungspfostens (105, 1404, 1406, 1806, 2006) aufgeschoben ist und sich in einem komprimierten Zustand befindet; wobei sich der dritte konvexe Abschnitt (603) des ersten Befestigungspfostens (105, 1404, 1406, 1806, 2006) über dem zweiten konvexen Abschnitt (501, 1601, 1811) des ersten Befestigungspfostens (105, 1404, 1406, 1806, 2006) befindet; und
durch das Durchgangsloch (604, 1605, 1810, 2011) an dem anderen Endabschnitt des Bügels (602, 1602, 1809, 2010) ist der andere Endabschnitt des Bügels (602, 1602, 1809, 2010) zwischen den zweiten konvexen Abschnitt (501, 1601, 1811) und einen dritten konvexen Abschnitt (603) des zweiten Befestigungspfostens geschoben; wobei ein viertes elastisches Element zwischen dem anderen Endabschnitt des Bügels (602, 1602, 1809, 2010) und dem dritten konvexen Abschnitt (603) des zweiten Befestigungspfostens angeordnet ist und das vierte elastische Element auf die Außenseite des zweiten Befestigungspfostens geschoben ist und sich in einem komprimierten Zustand befindet; und wobei sich der dritte konvexe Abschnitt (603) des zweiten Befestigungspfostens über dem zweiten konvexen Abschnitt (501, 1601, 1811) des zweiten Befestigungspfostens befindet.

3. Wärmeableitungsvorrichtung nach Anspruch 2, wobei der Bügel (602, 1602, 1809, 2010) zwei erste Querplatten, eine zweite Querplatte und zwei senkrechte Platten umfasst, wobei sich die zwei ersten Querplatten jeweils an den zwei Endabschnitten des Bügels (602, 1602, 1809, 2010) befinden und beide über der zweiten Querplatte angeordnet sind, und wobei die zwei senkrechten Platten separat zwischen den zwei Querplatten und der zweiten Querplatte angeordnet sind;
wobei der dritte Radiator (601, 1604, 1803, 2003) mit der zweiten Querplatte befestigt ist; und
wobei die erste Querplatte mit den Durchgangslöchern (604, 1605, 1810, 2011) versehen ist.

4. Wärmeableitungsvorrichtung nach Anspruch 2 oder 3, wobei eine obere Fläche eines Kantenteils einer Grundplatte (107, 1501, 2101) des zweiten Radiators (102, 1402, 1802, 2002) mit einer Nut versehen ist und sich eine Grundplatte (107, 1501, 2101) des dritten Radiators (601, 1604, 1803, 2003) in die Nut erstreckt; und
wobei ein Teil, der zu der Grundplatte (107, 1501, 2101) des dritten Radiators (601, 1604, 1803, 2003) gehört und der sich in die Nut erstreckt, mit dem Bügel (602, 1602, 1809, 2010) befestigt ist.

5. Wärmeableitungsvorrichtung nach einem der Ansprüche 2 bis 4, wobei eine Wärmesenke über oder unter dem Bügel (602, 1602, 1809, 2010) vorhanden ist.

6. Wärmeableitungsvorrichtung nach einem der Ansprüche 1 bis 5, wobei ein Radius, der zu einem Teil des ersten Befestigungspfostens (105, 1404, 1406, 1806, 2006) gehört und der sich über der oberen Fläche des Befestigungsrohrs (104, 1404) befindet, größer ist als ein Radius eines Teils, der zu dem ersten Befestigungspfosten (105, 1404, 1406, 1806, 2006) gehört und der sich unter der oberen Fläche des Befestigungsrohrs (104, 1404) befindet; und wobei der erste konvexe Abschnitt (502, 1405, 1807) des ersten Befestigungspfostens (105, 1404, 1406, 1806, 2006) ein Teil ist, der zu dem ersten Befestigungspfosten (105, 1404, 1406, 1806, 2006) gehört und der sich zwischen dem zweiten konvexen Abschnitt (501, 1601, 1811) des ersten Befestigungspfostens (105, 1404, 1406, 1806, 2006) und der oberen Fläche des ersten Befestigungsrohrs (104, 1404) befindet.

7. Wärmeableitungsvorrichtung nach einem der Ansprüche 1 bis 6, wobei der erste Befestigungspfosten (105, 1404, 1406, 1806, 2006) in das erste Befestigungsrohr (104, 1404) in einer Schraubverbindungsweise geschoben ist.

8. Wärmeableitungsvorrichtung nach einem der Ansprüche 1 bis 7, wobei der erste Radiator (101, 1401, 1801, 2001) mit einem konvexen Abschnitt des ersten Befestigungsrohrs (104, 1404) in einer genieteten Weise befestigt ist.

9. Wärmeableitungsvorrichtung nach einem der Ansprüche 1 bis 8, wobei eine Befestigungsplatte unter der PCB (103, 1403, 1804, 2004) angeordnet ist, wobei die Befestigungsplatte mit der PCB (103, 1403, 1804, 2004) befestigt ist und der erste Befestigungspfosten (105, 1404, 1406, 1806, 2006) durch die PCB (103, 1403, 1804, 2004) verläuft und fest mit der Befestigungsplatte in einer Schraubverbindungsweise verbunden ist.

10. Wärmeableitungsvorrichtung, umfassend:
einen ersten Radiator (101, 1401, 1801, 2001), einen zweiten Radiator (102, 1402, 1802, 2002) und eine erste Verbindungsvorrichtung (109, 1409), wobei der erste Radiator (101, 1401, 1801, 2001) und der zweite Radiator (102, 1402, 1802, 2002) auf einer Leiterplatte, PCB (103, 1403, 1804, 2004), durch die erste Verbindungsvorrichtung (109, 1409) angebracht sind;
wobei der erste Radiator (101, 1401, 1801, 2001) über einer ersten elektronischen Vorrichtung angeordnet ist und der zweite Radiator (102, 1402, 1802, 2002) über einer zweiten elektronischen Vorrichtung angeordnet ist; wobei die erste elektronische Vorrichtung und die zweite elektronische Vorrichtung an der PCB (103, 1403, 1804, 2004) befestigt sind;
wobei die erste Verbindungsvorrichtung (109, 1409) ein erstes Befestigungsrohr (104, 1404), einen ersten Befestigungspfosten (105, 1404, 1406, 1806, 2006) und ein erstes elastisches Element (106, 1408, 1808, 2009) umfasst;
wobei der erste Radiator (101, 1401, 1801, 2001) mit dem ersten Befestigungsrohr (104, 1404) durch einen ersten konvexen Abschnitt (502, 1405, 1807) des ersten Befestigungsrohrs befestigt ist; wobei der erste Befestigungspfosten (105, 1404, 1406, 1806, 2006) in das erste Befestigungsrohr (104, 1404) geschoben ist, wobei eine obere Fläche des ersten Befestigungsrohrs (104, 1404) an einer unteren Fläche eines konvexen Abschnitts des ersten Befestigungspfostens (105, 1404, 1406, 1806, 2006) anliegt und eine untere Fläche des ersten Befestigungsrohrs (104, 1404) an einer oberen Fläche der PCB (103, 1403, 1804, 2004) anliegt;
wobei das erste Befestigungsrohr (104, 1404) und der erste Befestigungspfosten (105, 1404, 1406, 1806, 2006) durch den zweiten Radiator (102, 1402, 1802, 2002) und den ersten Radiator (101, 1401, 1801, 2001) von oben nach unten verlaufen;
wobei das erste elastische Element (106, 1408, 1808, 2009) zwischen dem zweiten Radiator (102, 1402, 1802, 2002) und dem konvexen Abschnitt des Befestigungspfostens angeordnet ist und das erste elastische Element (106, 1408, 1808, 2009) auf eine Außenseite des ersten Befestigungsrohrs (104, 1404) geschoben ist und sich in einem komprimierten Zustand befindet; und
wobei die PCB (103, 1403, 1804, 2004) mit dem ersten Befestigungspfosten (105, 1404, 1406, 1806, 2006) befestigt ist;
**dadurch gekennzeichnet, dass**
die Wärmeableitungsvorrichtung ferner einen dritten Radiator (601, 1604, 1803, 2003) umfasst und der dritte Radiator (601, 1604, 1803, 2003) über einer dritten elektronischen Vorrichtung angeordnet ist und an den zweiten Radiator (102, 1402, 1802, 2002) in einer selben Ebene angrenzt; wobei der zweite Radiator (102, 1402, 1802, 2002) und der dritte Radiator (601, 1604, 1803, 2003) an der PCB (103, 1403, 1804, 2004) durch die erste Verbindungsvorrichtung (109, 1409) und eine zweite Verbindungsvorrichtung (609, 1609) angebracht sind;
die zweite Verbindungsvorrichtung (609, 1609) ein zweites Befestigungsrohr, einen zweiten Befestigungspfosten und ein zweites elastisches Element (1603, 1812, 2012) umfasst;
der zweite Radiator (102, 1402, 1802, 2002) mit dem zweiten Befestigungsrohr durch einen zweiten konvexen Abschnitt (501, 1601, 1811) des zweiten Befestigungsrohrs befestigt ist; wobei der zweite Befestigungspfosten in das zweite Befestigungsrohr geschoben ist, wobei eine obere Fläche des zweiten Befestigungsrohrs an einer unteren Fläche eines konvexen Abschnitts des zweiten Befestigungspfostens anliegt und eine untere Fläche des zweiten Befestigungsrohrs an der oberen Fläche der PCB (103, 1403, 1804, 2004) anliegt;
das zweite Befestigungsrohr und der zweite Befestigungspfosten durch den zweiten Radiator (102, 1402, 1802, 2002) und den ersten Radiator (101, 1401, 1801, 2001) von oben nach unten verlaufen;
das zweite elastische Element (1603, 1812, 2012) zwischen dem zweiten Radiator (102, 1402, 1802, 2002) und dem konvexen Abschnitt des zweiten Befestigungspfostens angeordnet ist und das zweite elastische Element (1603, 1812, 2012) auf eine Außenseite des zweiten Befestigungsrohrs geschoben ist und sich in einem komprimierten Zustand befindet;
die PCB (103, 1403, 1804, 2004) mit dem zweiten Befestigungspfosten befestigt ist.

11. Wärmeableitungsvorrichtung nach Anspruch 10, wobei die Wärmeableitungsvorrichtung ferner Folgendes umfasst:
ein Bügel (602, 1602, 1809, 2010) ist an einer Seite des dritten Radiators (601, 1604, 1803, 2003) in der Nähe des zweiten Radiators (102, 1402, 1802, 2002) befestigt und zwei Endabschnitte des Bügels (602, 1602, 1809, 2010) sind mit Durchgangslöchern (604, 1605, 1810, 2011) versehen;
durch das Durchgangsloch (604, 1605, 1810, 2011) eines Endabschnitts des Bügels (602, 1602, 1809, 2010) ist ein Endabschnitt des Bügels (602, 1602, 1809, 2010) zwischen einen zweiten konvexen Abschnitt (501, 1601, 1811) des ersten Befestigungsrohrs (104, 1404) und den konvexen Abschnitt des ersten Befestigungspfostens (105, 1404, 1406, 1806, 2006) geschoben; wobei ein drittes elastisches Element (603, 1603) zwischen einem Endabschnitt des Bügels (602, 1602, 1809, 2010) und dem konvexen Abschnitt des ersten Befestigungspfostens (105, 1404, 1406, 1806, 2006) angeordnet ist und das elastische Element auf die Außenseite des ersten Befestigungspfostens (105, 1404, 1406, 1806, 2006) geschoben ist und sich in einem komprimierten Zustand befindet; wobei sich der zweite konvexe Abschnitt (501, 1601, 1811) des ersten Befestigungsrohrs (104, 1404) über dem ersten konvexen Abschnitt (502, 1405, 1807) des ersten Befestigungsrohrs (104, 1404) befindet; und
durch das Durchgangsloch (604, 1605, 1810, 2011) an dem anderen Endabschnitt des Bügels (602, 1602, 1809, 2010) ist der andere Endabschnitt des Bügels (602, 1602, 1809, 2010) zwischen den zweiten konvexen Abschnitt (501, 1601, 1811) des zweiten Befestigungsrohrs und den konvexen Abschnitt des zweiten Befestigungspfostens geschoben; wobei ein viertes elastisches Element zwischen dem anderen Endabschnitt des Bügels (602, 1602, 1809, 2010) und dem konvexen Abschnitt des zweiten Befestigungspfostens angeordnet ist und das vierte elastische Element auf die Außenseite des zweiten Befestigungsrohrs geschoben ist und sich in einem komprimierten Zustand befindet; und wobei sich der zweite konvexe Abschnitt (501, 1601, 1811) des zweiten Befestigungsrohrs über einem ersten konvexen Abschnitt (502, 1405, 1807) des zweiten Befestigungsrohrs befindet.

12. Elektronische Vorrichtung, umfassend eine Leiterplatte, PCB (103, 1403, 1804, 2004), wobei die Wärmeableitungsvorrichtung nach einem der Ansprüche 1 bis 9 an der PCB (103, 1403, 1804, 2004) angeordnet ist.

13. Elektronische Vorrichtung, umfassend eine Leiterplatte, PCB (103, 1403, 1804, 2004), wobei die Wärmeableitungsvorrichtung nach Anspruch 10 oder 11 an der PCB (103, 1403, 1804, 2004) angeordnet ist.

## Revendications

1. Dispositif de dissipation thermique, comprenant :
un premier radiateur (101, 1401, 1801, 2001), un deuxième radiateur (102, 1402, 1802, 2002) et un premier dispositif de liaison (109, 1409), le premier radiateur (101, 1401, 1801, 2001) et le deuxième radiateur (102, 1402, 1802, 2002) étant attachés sur une carte de circuit imprimé, PCB, (103, 1403, 1804, 2004) par le biais du premier dispositif de liaison (109, 1409) ;
le premier radiateur (101, 1401, 1801, 2001) étant placé au-dessus d'un premier dispositif électronique, et le deuxième radiateur (102, 1402, 1802, 2002) étant placé au-dessus d'un deuxième dispositif électronique ; le premier dispositif électronique et le deuxième dispositif électronique étant fixés sur la PCB (103, 1403, 1804, 2004) ;
le premier dispositif de liaison (109, 1409) comprenant un premier tube de fixation (104, 1404), une première colonnette de fixation (105, 1404, 1406, 1806, 2006) et un premier élément élastique (106, 1408, 1808, 2009) ;
le premier radiateur (101, 1401, 1801, 2001) étant fixé au premier tube de fixation (104, 1404) ; la première colonnette de fixation (105, 1404, 1406, 1806, 2006) étant emmanchée dans le premier tube de fixation (104, 1404), une surface supérieure du premier tube de fixation (104, 1404) venant en butée contre une surface inférieure d'une première portion convexe (502, 1405, 1807) de la première colonnette de fixation (105, 1404, 1406, 1806, 2006) et une surface inférieure du premier tube de fixation (104, 1404) venant en butée contre une surface supérieure de la PCB (103, 1403, 1804, 2004) ; la première colonnette de fixation (105, 1404, 1406, 1806, 2006) traversant le deuxième radiateur (102, 1402, 1802, 2002) et le premier radiateur (101, 1401, 1801, 2001) de haut en bas ;
le premier élément élastique (106, 1408, 1808, 2009) étant placé entre le deuxième radiateur (102, 1402, 1802, 2002) et une deuxième portion convexe (501, 1601, 1811) de la première colonnette de fixation (105, 1404, 1406, 1806, 2006), le premier élément élastique (106, 1408, 1808, 2009) étant emmanché sur un côté extérieur de la première colonnette de fixation (105, 1404, 1406, 1806, 2006) et adoptant un état comprimé, et la deuxième portion convexe (501, 1601, 1811) se situant au-dessus de la première portion convexe (502, 1405, 1807) de la première colonnette de fixation ; et
la PCB (103, 1403, 1804, 2004) étant fixée à la première colonnette de fixation (105, 1404, 1406, 1806, 2006) ;
**caractérisé en ce que**
le dispositif de dissipation thermique comprend en outre un troisième radiateur (601, 1604, 1803, 2003), et le troisième radiateur (601, 1604, 1803, 2003) est placé au-dessus d'un troisième dispositif électronique et est adjacent au deuxième radiateur (102, 1402, 1802, 2002) dans un même plan ; le deuxième radiateur (102, 1402, 1802, 2002) et le troisième radiateur (601, 1604, 1803, 2003) sont attachés sur la PCB (103, 1403, 1804, 2004) par le biais du premier dispositif de liaison (109, 1409) et d'un deuxième dispositif de liaison (609, 1609) ;
le deuxième dispositif de liaison (609, 1609) comprend un deuxième tube de fixation, une deuxième colonnette de fixation et un deuxième élément élastique (1603, 1812, 2012);
le deuxième radiateur (102, 1402, 1802, 2002) est fixé au deuxième tube de fixation ;
la deuxième colonnette de fixation est emmanchée dans le deuxième tube de fixation, une surface supérieure du deuxième tube de fixation vient en butée contre une surface inférieure d'une deuxième portion convexe (501, 1601, 1811) de la deuxième colonnette de fixation et une surface inférieure du deuxième tube de fixation vient en butée contre la surface supérieure de la PCB (103, 1403, 1804, 2004) ; la deuxième colonnette de fixation traverse le deuxième radiateur (102, 1402, 1802, 2002) et le premier radiateur (101, 1401, 1801, 2001) de haut en bas ;
le deuxième élément élastique (1603, 1812, 2012) est placé entre le deuxième radiateur (102, 1402, 1802, 2002) et la deuxième portion convexe (501, 1601, 1811) de la deuxième colonnette de fixation, le deuxième élément élastique (1603, 1812, 2012) est emmanché sur un côté extérieur de la deuxième colonnette de fixation et adopte un état comprimé, et la deuxième portion convexe (501, 1601, 1811) se situe au-dessus de la première portion convexe (502, 1405, 1807) de la première colonnette de fixation ; la PCB (103, 1403, 1804, 2004) est fixée à la deuxième colonnette de fixation.

2. Dispositif de dissipation thermique selon la revendication 1, le dispositif de dissipation thermique comprenant en outre :
un étrier (602, 1602, 1809, 2010) est fixé sur un côté du troisième radiateur (601, 1604, 1803, 2003) proche du deuxième radiateur (102, 1402, 1802, 2002), et deux portions d'extrémité de l'étrier (602, 1602, 1809, 2010) sont pourvues de trous traversants (604, 1605, 1810, 2011) ;
au travers du trou traversant (604, 1605, 1810, 2011) sur une portion d'extrémité de l'étrier (602, 1602, 1809, 2010), une portion d'extrémité de l'étrier (602, 1602, 1809, 2010) est emmanchée entre la deuxième portion convexe (501, 1601, 1811) et une troisième portion convexe (603) de la première colonnette de fixation (105, 1404, 1406, 1806, 2006) ; un troisième élément élastique (603, 1603) est placé entre une portion d'extrémité de l'étrier (602, 1602, 1809, 2010) et la troisième portion convexe (603) de la première colonnette de fixation (105, 1404, 1406, 1806, 2006), et l'élément élastique est emmanché sur le côté extérieur de la première colonnette de fixation (105, 1404, 1406, 1806, 2006) et adopte un état comprimé ; la troisième portion convexe (603) de la première colonnette de fixation (105, 1404, 1406, 1806, 2006) se situe au-dessus de la deuxième portion convexe (501, 1601, 1811) de la première colonnette de fixation (105, 1404, 1406, 1806, 2006) ; et
au travers du trou traversant (604, 1605, 1810, 2011) sur l'autre portion d'extrémité de l'étrier (602, 1602, 1809, 2010), l'autre portion d'extrémité de l'étrier (602, 1602, 1809, 2010) est emmanchée entre la deuxième portion convexe (501, 1601, 1811) et une troisième portion convexe (603) de la deuxième colonnette de fixation ; un quatrième élément élastique est placé entre l'autre portion d'extrémité de l'étrier (602, 1602, 1809, 2010) et la troisième portion convexe (603) de la deuxième colonnette de fixation, et le quatrième élément élastique est emmanché sur le côté extérieur de la deuxième colonnette de fixation et adopte un état comprimé ; et la troisième portion convexe (603) de la deuxième colonnette de fixation se situe au-dessus de la deuxième portion convexe (501, 1601, 1811) de la deuxième colonnette de fixation.

3. Dispositif de dissipation thermique selon la revendication 2, l'étrier (602, 1602, 1809, 2010) comprenant deux premières plaques transversales, une deuxième plaque transversale et deux plaques verticales, les deux premières plaques transversales se situant respectivement sur les deux portions d'extrémité de l'étrier (602, 1602, 1809, 2010) et étant toutes deux placées au-dessus de la deuxième plaque transversale, et les deux plaques verticales étant placées séparément entre les deux plaques transversales et la deuxième plaque transversale ;
le troisième radiateur (601, 1604, 1803, 2003) étant fixé à la deuxième plaque transversale ; et
la première plaque transversale étant pourvue des trous traversants (604, 1605, 1810, 2011).

4. Dispositif de dissipation thermique selon la revendication 2 ou 3, dans lequel une surface supérieure d'une partie de bord d'une embase (107, 1501, 2101) du deuxième radiateur (102, 1402, 1802, 2002) est pourvue d'une rainure, et une embase (107, 1501, 2101) du troisième radiateur (601, 1604, 1803, 2003) s'étend jusque dans la rainure ; et
une partie de l'embase (107, 1501, 2101) du troisième radiateur (601, 1604, 1803, 2003) qui s'étend jusque dans la rainure est fixée à l'étrier (602, 1602, 1809, 2010).

5. Dispositif de dissipation thermique selon l'une quelconque des revendications 2 à 4, dans lequel un puits thermique est présent au-dessus ou au-dessous de l'étrier (602, 1602, 1809, 2010).

6. Dispositif de dissipation thermique selon l'une quelconque des revendications 1 à 5, dans lequel
un rayon d'une partie de la première colonnette de fixation (105, 1404, 1406, 1806, 2006) qui est situé au-dessus de la surface supérieure du tube de fixation (104, 1404) est supérieur à un rayon d'une partie de la première colonnette de fixation (105, 1404, 1406, 1806, 2006) qui est située au-dessous de la surface supérieure du tube de fixation (104, 1404) ; et la première portion convexe (502, 1405, 1807) de la première colonnette de fixation (105, 1404, 1406, 1806, 2006) est une partie de la première colonnette de fixation (105, 1404, 1406, 1806, 2006) qui est située entre la deuxième portion convexe (501, 1601, 1811) de la première colonnette de fixation (105, 1404, 1406, 1806, 2006) et la surface supérieure du premier tube de fixation (104, 1404).

7. Dispositif de dissipation thermique selon l'une quelconque des revendications 1 à 6, dans lequel la première colonnette de fixation (105, 1404, 1406, 1806, 2006) est emmanchée dans le premier tube de fixation (104, 1404) par liaison filetée.

8. Dispositif de dissipation thermique selon l'une quelconque des revendications 1 à 7, dans lequel le premier radiateur (101, 1401, 1801, 2001) est fixé à une portion convexe du premier tube de fixation (104, 1404) par rivetage.

9. Dispositif de dissipation thermique selon l'une quelconque des revendications 1 à 8, dans lequel une plaque de fixation est placée au-dessous de la PCB (103, 1403, 1804, 2004), la plaque de fixation est fixée à la PCB (103, 1403, 1804, 2004), et la première colonnette de fixation (105, 1404, 1406, 1806, 2006) traverse la PCB (103, 1403, 1804, 2004) et est liée à demeure à la plaque de fixation par liaison filetée.

10. Dispositif de dissipation thermique, comprenant :
un premier radiateur (101, 1401, 1801, 2001), un deuxième radiateur (102, 1402, 1802, 2002) et un premier dispositif de liaison (109, 1409), le premier radiateur (101, 1401, 1801, 2001) et le deuxième radiateur (102, 1402, 1802, 2002) étant attachés sur une carte de circuit imprimé, PCB, (103, 1403, 1804, 2004) par le biais du premier dispositif de liaison (109, 1409) ;
le premier radiateur (101, 1401, 1801, 2001) étant placé au-dessus d'un premier dispositif électronique, et le deuxième radiateur (102, 1402, 1802, 2002) étant placé au-dessus d'un deuxième dispositif électronique ; le premier dispositif électronique et le deuxième dispositif électronique étant fixés sur la PCB (103, 1403, 1804, 2004) ;
le premier dispositif de liaison (109, 1409) comprenant un premier tube de fixation (104, 1404), une première colonnette de fixation (105, 1404, 1406, 1806, 2006) et un premier élément élastique (106, 1408, 1808, 2009) ;
le premier radiateur (101, 1401, 1801, 2001) étant fixé au premier tube de fixation (104, 1404) par le biais d'une première portion convexe (502, 1405, 1807) du premier tube de fixation, la première colonnette de fixation (105, 1404, 1406, 1806, 2006) étant emmanchée dans le premier tube de fixation (104, 1404), une surface supérieure du premier tube de fixation (104, 1404) venant en butée contre une surface inférieure d'une portion convexe de la première colonnette de fixation (105, 1404, 1406, 1806, 2006) et une surface inférieure du premier tube de fixation (104, 1404) venant en butée contre une surface supérieure de la PCB (103, 1403, 1804, 2004) ;
le premier tube de fixation (104, 1404) et la première colonnette de fixation (105, 1404, 1406, 1806, 2006) traversant le deuxième radiateur (102, 1402, 1802, 2002) et le premier radiateur (101, 1401, 1801, 2001) de haut en bas ;
le premier élément élastique (106, 1408, 1808, 2009) étant placé entre le deuxième radiateur (102, 1402, 1802, 2002) et la portion convexe de la colonnette de fixation, et le premier élément élastique (106, 1408, 1808, 2009) étant emmanché sur un côté extérieur du premier tube de fixation (104, 1404) et adoptant un état comprimé ; et
la PCB (103, 1403, 1804, 2004) étant fixée à la première colonnette de fixation (105, 1404, 1406, 1806, 2006) ;
**caractérisé en ce que**
le dispositif de dissipation thermique comprend en outre un troisième radiateur (601, 1604, 1803, 2003), et le troisième radiateur (601, 1604, 1803, 2003) est placé au-dessus d'un troisième dispositif électronique et est adjacent au deuxième radiateur (102, 1402, 1802, 2002) dans un même plan ; le deuxième radiateur (102, 1402, 1802, 2002) et le troisième radiateur (601, 1604, 1803, 2003) sont attachés sur la PCB (103, 1403, 1804, 2004) par le biais du premier dispositif de liaison (109, 1409) et d'un deuxième dispositif de liaison (609, 1609) ;
le deuxième dispositif de liaison (609, 1609) comprend un deuxième tube de fixation, une deuxième colonnette de fixation et un deuxième élément élastique (1603, 1812, 2012);
le deuxième radiateur (102, 1402, 1802, 2002) est fixé au deuxième tube de fixation par le biais d'une deuxième portion convexe (501, 1601, 1811) du deuxième tube de fixation ; la deuxième colonnette de fixation est emmanchée dans le deuxième tube de fixation, une surface supérieure du deuxième tube de fixation vient en butée contre une surface inférieure d'une portion convexe de la deuxième colonnette de fixation et une surface inférieure du deuxième tube de fixation vient en butée contre la surface supérieure de la PCB (103, 1403, 1804, 2004) ;
le deuxième tube de fixation et la deuxième colonnette de fixation traversent le deuxième radiateur (102, 1402, 1802, 2002) et le premier radiateur (101, 1401, 1801, 2001) de haut en bas ;
le deuxième élément élastique (1603, 1812, 2012) est placé entre le deuxième radiateur (102, 1402, 1802, 2002) et la portion convexe de la deuxième colonnette de fixation, et le deuxième élément élastique (1603, 1812, 2012) est emmanché sur un côté extérieur du deuxième tube de fixation et adopte un état comprimé ;
la PCB (103, 1403, 1804, 2004) est fixée à la deuxième colonnette de fixation.

11. Dispositif de dissipation thermique selon la revendication 10, le dispositif de dissipation thermique comprenant en outre :
un étrier (602, 1602, 1809, 2010) est fixé sur un côté du troisième radiateur (601, 1604, 1803, 2003) proche du deuxième radiateur (102, 1402, 1802, 2002), et deux portions d'extrémité de l'étrier (602, 1602, 1809, 2010) sont pourvues de trous traversants (604, 1605, 1810, 2011) ;
au travers du trou traversant (604, 1605, 1810, 2011) d'une portion d'extrémité de l'étrier (602, 1602, 1809, 2010), une portion d'extrémité de l'étrier (602, 1602, 1809, 2010) est emmanchée entre une deuxième portion convexe (501, 1601, 1811) du premier tube de fixation (104, 1404) et la portion convexe de la première colonnette de fixation (105, 1404, 1406, 1806, 2006) ; un troisième élément élastique (603, 1603) est placé entre une portion d'extrémité de l'étrier (602, 1602, 1809, 2010) et la portion convexe de la première colonnette de fixation (105, 1404, 1406, 1806, 2006), et l'élément élastique est emmanché sur le côté extérieur de la première colonnette de fixation (105, 1404, 1406, 1806, 2006) et adopte un état comprimé ; la deuxième portion convexe (501, 1601, 1811) du premier tube de fixation (104, 1404) se situe au-dessus de la première portion convexe (502, 1405, 1807) du premier tube de fixation (104, 1404) ; et
au travers du trou traversant (604, 1605, 1810, 2011) sur l'autre portion d'extrémité de l'étrier (602, 1602, 1809, 2010), l'autre portion d'extrémité de l'étrier (602, 1602, 1809, 2010) est emmanchée entre la deuxième portion convexe (501, 1601, 1811) du deuxième tube de fixation et la portion convexe de la deuxième colonnette de fixation ;
un quatrième élément élastique est placé entre l'autre portion d'extrémité de l'étrier (602, 1602, 1809, 2010) et la portion convexe de la deuxième colonnette de fixation, et le quatrième élément élastique est emmanché sur le côté extérieur du deuxième tube de fixation et adopte un état comprimé ; et la deuxième portion convexe (501, 1601, 1811) du deuxième tube de fixation se situe au-dessus d'une première portion convexe (502, 1405, 1807) du deuxième tube de fixation.

12. Dispositif électronique, comprenant une carte de circuit imprimé, PCB, (103, 1403, 1804, 2004), le dispositif de dissipation thermique selon l'une quelconque des revendications 1 à 9 étant placé sur la PCB (103, 1403, 1804, 2004).

13. Dispositif électronique, comprenant une carte de circuit imprimé, PCB, (103, 1403, 1804, 2004), le dispositif de dissipation thermique selon la revendication 10 ou 11 étant placé sur la PCB (103, 1403, 1804, 2004).
